(19) Europäisches Patentamt / European Patent Office / Office européen des brevets

(11) **EP 4 632 012 A1**

(12) **EUROPEAN PATENT APPLICATION**
published in accordance with Art. 153(4) EPC

(43) Date of publication:
**15.10.2025  Bulletin 2025/42**

(21) Application number: 23900541.6

(22) Date of filing: **29.11.2023**

(51) International Patent Classification (IPC):
**C08L 101/00** (2006.01)        **B32B 15/08** (2006.01)
**C08F 299/02** (2006.01)        **C08K 7/22** (2006.01)
**H05K 1/03** (2006.01)

(52) Cooperative Patent Classification (CPC):
**B32B 15/08; C08F 299/02; C08K 7/22;**
**C08L 101/00; H05K 1/03**

(86) International application number:
**PCT/JP2023/042733**

(87) International publication number:
**WO 2024/122426 (13.06.2024 Gazette 2024/24)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **06.12.2022  JP 2022194569**

(71) Applicant: **Zeon Corporation**
**Tokyo 100-8246 (JP)**

(72) Inventors:
• **YAGYU, Sakyo**
**Tokyo 100-8246 (JP)**
• **MORIMURA, Miki**
**Tokyo 100-8246 (JP)**

(74) Representative: **Kraus & Lederer PartGmbB**
**Thomas-Wimmer-Ring 15**
**80539 München (DE)**

(54) **RESIN COMPOSITION, PREPREG, METAL FOIL-CLAD LAMINATE, AND PRINTED SUBSTRATE**

(57)    To provide a resin composition and prepreg having excellent dielectric property and reliability, and a metal foil-clad laminate and printed circuit board having excellent reliability. A resin composition comprising hollow particles and a matrix resin, wherein the hollow particles comprises a shell containing a resin and a hollow portion surrounded by the shell; the hollow particles have a void ratio of 55% or more; the hollow particles have a relative permittivity of 1.50 or less at a frequency of 10 GHz; the hollow particles have a reactive unsaturated bond on a surface of the particles; the hollow particles have an unsaturated bond amount per unit area of 0.010 $mmol/m^2$ or more, and wherein the matrix resin comprises a matrix resin containing a functional group which is reactive with the reactive unsaturated bond of the hollow particles.

**EP 4 632 012 A1**

**Description**

Technical Field

The present disclosure relates to a resin composition comprising hollow particles. The present disclosure also relates to a prepreg, metal foil-clad laminate and printed circuit board produced by use of the resin composition.

Background Art

Recently, in response to trends for high-speed circuits in the telecommunications industry, the development of a resin material with low transmission loss, that is, a resin material having a low relative permittivity and a low dielectric dissipation factor, has been pursed. Various kinds of techniques are known as a method for decreasing the permittivity and dielectric dissipation factor of a resin material by using an air having a relative permittivity of 1 and a dielectric dissipation factor of 0, such as making a resin material porous and adding hollow particles to a resin material.

For example, Patent Document 1 discloses a resin composition containing hollow particles which have a shell formed of the polymer of a monomer containing an aromatic ring and reactive groups, such as divinylbenzene, and which have an average particle diameter of from $0.010\ \mu m$ to $1\ \mu m$. Patent Document 2 discloses a resin composition containing hollow particles which have a shell formed of silica and which have an average particle diameter of from $0.1\ \mu m$ to $20\ \mu m$. The patent documents describe that the permittivity and dielectric dissipation factor of the resin compositions are decreased by the hollow particles, and the resin compositions are for use in a prepreg, a metal foil-clad laminate, a printed circuit board and so on.

Citation List

[Patent Documents]

Patent Document 1: International Publication No. WO2022/202046
Patent Document 2: Japanese Patent Application Laid-Open (JP-A) No. 2008-31409

Summary

Technical Problem

However, there is a demand for further improvement in the dielectric property of a resin composition containing hollow particles.

Meanwhile, a metal foil-clad laminate comprising an insulation layer containing hollow particles is likely to cause the following problems: the adhesion between the insulation layer and the metal foil is insufficient since the interface between the hollow particles and a matrix resin is likely to be peeled off, and water enters the interface between the hollow particles and the matrix resin, causing a failure such as ion migration and a problem such as deterioration in dielectric property.

Since resin has a low relative permittivity compared to silica, there is a demand for a resin composition which contains hollow particles having a shell formed of a resin and which can provide electronic devices having excellent reliability.

An object of the present disclosure is to provide a resin composition and prepreg having excellent dielectric property and reliability, and to provide a metal foil-clad laminate and printed circuit board having excellent reliability.

Solution to Problem

The inventors of the present disclosure found that a resin composition containing hollow particles having a shell formed of a resin, exerts excellent reliability when the hollow particles have a specific amount or more of reactive unsaturated bonds on the surface and when a matrix resin contains a functional group which is reactive with the reactive unsaturated bond of the hollow particles. Based on this finding, they achieved the present disclosure.

According to the present disclosure, there is provided a resin composition comprising hollow particles and a matrix resin,

wherein the hollow particles comprises a shell containing a resin and a hollow portion surrounded by the shell; the hollow particles have a void ratio of 55% or more; the hollow particles have a relative permittivity of 1.50 or less at a frequency of 10 GHz; the hollow particles have a reactive unsaturated bond on a surface of the particles; the hollow particles have an unsaturated bond amount per unit area of 0.010 mmol/m$^2$ or more, which is obtained from an iodine value and specific surface area of the hollow particles by the following formula (A):

Unsaturated bond amount (mmol/m$^2$) = Iodine value (mmol/g) / Specific surface area (m$^2$/g)          Formula (A),

and

wherein the matrix resin comprises a matrix resin containing a functional group which is reactive with the reactive unsaturated bond of the hollow particles.

According to the present disclosure, there is also provided a prepreg obtained by impregnating a substrate with the resin composition of the present disclosure and heat-drying the substrate.

According to the present disclosure, there is also provided a metal foil-clad laminate obtained by hot-pressing a prepreg laminate which is a laminate of the prepregs of the present disclosure and a metal foil which is in contact with the prepreg laminate.

According to the present disclosure, there is also provided a metal foil-clad laminate comprising an insulation layer comprising a cured product of the resin composition of the present disclosure and a substrate, and a metal foil in contact with the insulation layer, wherein at least some of the hollow particles in the cured product of the resin composition are cross-linked to the matrix resin.

According to the present disclosure, there is also provided a printed circuit board comprising the metal foil-clad laminate of the present disclosure.

Advantageous Effects of Invention

According to the present disclosure as described above, a resin composition and prepreg having excellent dielectric property and reliability are provided. In addition, according to the present disclosure, a metal foil-clad laminate and printed circuit board having excellent reliability are provided.

Brief Description of Drawings

[FIG. 1] FIG. 1 is a diagram illustrating an example of the method for producing the hollow particles used in the present disclosure.
[FIG. 2] FIG. 2 is a diagram illustrating an example of the stirring apparatus used in the solvent removal step.

Description of Embodiments

Hereinafter, the resin composition, resin structure, prepreg, metal foil-clad laminate and printed circuit board of the present disclosure will be described in detail.

In the present disclosure, "to" which shows a numerical range is used to describe a range in which the numerical values described before and after "to" indicate the lower limit value and the upper limit value.

1. Resin composition

The resin composition of the present disclosure is a resin composition comprising hollow particles and a matrix resin,

wherein the hollow particles comprises a shell containing a resin and a hollow portion surrounded by the shell; the hollow particles have a void ratio of 55% or more; the hollow particles have a relative permittivity of 1.50 or less at a frequency of 10 GHz; the hollow particles have a reactive unsaturated bond on the surface of the particles; the hollow particles have an unsaturated bond amount per unit area of 0.010 mmol/m$^2$ or more, which is obtained from the iodine value and specific surface area of the hollow particles by the following formula (A):

Unsaturated bond amount (mmol/m$^2$) = Iodine value (mmol/g) / Specific surface area (m$^2$/g)          Formula (A),

and

wherein the matrix resin comprises a matrix resin containing a functional group which is reactive with the reactive unsaturated bond of the hollow particles.

The resin composition of the present disclosure has excellent dielectric property, since it contains the hollow particles which have the shell containing the resin and which have a void ratio of 55% or more. For example, by heat-drying or hot-pressing the resin composition of the present disclosure, the reactive unsaturated bond on the surface of the hollow particles reacts with the functional group of the matrix resin to form a covalent bond. Accordingly, in the resin structure obtained by, for example, heat-drying or hot-pressing the resin composition of the present disclosure, since the hollow particle surface is cross-linked to the matrix resin, the interface between the hollow particles and the matrix resin has excellent adhesion, and the interface between the hollow particles and the matrix resin is less likely to be peeled off. In addition, since water is less likely to enter the interface between the hollow particles and the matrix resin, an increase in the dielectric dissipation factor by the water, ion migration or the like is less likely to occur. The dielectric dissipation factor is the degree of energy loss when a part of the energy is turned into heat and lost when an electric field is applied. Accordingly, by decreasing the amount of water, energy loss can be reduced, and the dielectric dissipation factor can be decreased.

In addition, in the resin structure obtained by use of the resin composition of the present disclosure, the hollow particles are less likely to collapse, and the voids are likely to be retained; therefore, excellent dielectric property is exerted. It is presumed that the collapse of the hollow particles is suppressed since a three-dimensional crosslinked structure is formed in the vicinity of the hollow particle surface after the reactive unsaturated bond on the hollow particle surface reacts with the functional group of the matrix resin.

In addition, in the resin composition of the present disclosure, the polarity of the hollow particles having the reactive unsaturated bond is close to that of the matrix resin having the functional group, and the hollow particles and the matrix resin have high affinity for each other; therefore, the dispersibility of the hollow particles in the resin composition is excellent. Accordingly, in the resin structure obtained by use of the resin composition of the present disclosure, the aggregation of the hollow particles is suppressed; the hollow particles are uniformly dispersed; uniform pressure is likely to be applied when pressurized; and the collapse of the hollow particles is further suppressed, accordingly.

In the present disclosure, as the relative permittivity and the dielectric dissipation factor decrease, the dielectric property improves. Also in the present disclosure, the reliability is mainly the reliability of the case of being used in a printed circuit board, and more specifically, it is evaluated by the metal foil peel strength and the HAST test. The Df (dielectric dissipation factor) change amount before and after a water absorption test on a resin film, which is carried out in Examples and Comparative Examples described later, corresponds to a simplified version of the HAST test on the metal foil-clad laminate.

Hereinafter, the hollow particles contained in the resin composition of the present disclosure, the method for producing the hollow particles, and the matrix resin will be described in detail.

[Hollow particles]

The hollow particles used in the present disclosure are hollow particles comprising a shell (outer shell), which contains a resin, and a hollow portion surrounded by the shell. The hollow particles have the reactive unsaturated bond on the outer surface of the shell.

As the reactive unsaturated bond, examples include, but are not limited to, a reactive unsaturated bond contained in a vinyl group, a (meth)acryloyl group, an allyl group, a butenyl group, a maleimide group, a nadimide group, a propargyl group, an ethynyl group or the like. The reactive unsaturated bond is preferably an ethylenically unsaturated bond, and more preferably an ethylenically unsaturated bond contained in at least one selected from a vinyl group, a (meth)acryloyl group and an allyl group.

In the hollow particles used in the present disclosure, the reactive unsaturated bond on the outer surface of the shell is preferably the reactive unsaturated bond contained in the crosslinkable monomer unit. That is, at least one polymerizable functional group of the crosslinkable monomer is preferably present on the shell surface while it remains unreacted.

The hollow particles used in the present disclosure have an unsaturated bond amount per unit area of 0.010 mmol/$m^2$ or more, which is obtained from the iodine value and the specific surface area by the following formula (A):

$$\text{Unsaturated bond amount (mmol/m}^2\text{)} = \text{Iodine value (mmol/g) / Specific surface area (m}^2\text{/g)} \qquad \text{Formula (A)}.$$

In the present disclosure, the iodine value of the hollow particles is measured according to JIS K 0070.

Also in the present disclosure, the specific surface area of the hollow particles can be calculated by the following formula (B) from the volume average particle diameter of the hollow particles and the apparent density $D_1$ thereof, on the supposition that the hollow particles are spherical. In the following formula (B), the volume average particle diameter is a value expressed in units of "m", and the apparent density $D_1$ is a value expressed in units of "g/$m^3$". Also in the formula (B), the value of the volume average particle diameter and that of the apparent density $D_1$ are values with two significant digits, and the specific surface area is a value rounded off to three decimal places.

Specific surface area (m²/g) = 6 / (Volume average particle diameter (m) × Apparent density $D_1$ (g/ m³))      Formula (B)

The unsaturated bond amount can be used as the index of the amount of the reactive unsaturated bond on the surface of the hollow particles. The unsaturated bond amount of the hollow particles used in the present disclosure is only required to be 0.010 mmol/m² or more. From the viewpoint of improving the reliability, the unsaturated bond amount is preferably 0.030 mmol/m² or more, more preferably 0.050 mmol/m² or more, still more preferably 0.070 mmol/m² or more, and even more preferably 0.080 mmol/m² or more. Also, in the case where the unsaturated bond amount of the hollow particles is 0.165 mmol/m² or more, the solvent resistance of the hollow particles improves and, when the resin composition of the present disclosure contains a solvent, solvent penetration into the hollow particles is suppressed. To increase the unsaturated bond amount of the hollow particles to 0.165 mmol/m² or more, for example, it is effective to add a crosslinkable monomer having a solubility in water at 20°C of from 0.5 g/L to 1000 g/L, during a polymerization reaction. It is presumed that by adding the crosslinkable monomer during a polymerization reaction to further continue the polymerization reaction, the crosslinking density of the shell is increased, and the solvent resistance of the hollow particles is improved, accordingly.

The upper limit of the unsaturated bond amount of the hollow particles is not particularly limited. From the viewpoint of improving the dielectric property, it is preferably 0.400 mmol/m² or less, more preferably 0.300 mmol/m² or less, and still more preferably 0.200 mmol/m² or less.

In the hollow particles used in the present disclosure, the hollow portion is a hollow space clearly distinguished from the shell. The shell of the hollow particles may have a porous structure. In this case, the hollow portion has a size that is clearly distinguishable from many minute spaces uniformly dispersed in the porous structure. From the viewpoint of mechanical strength and so on, the hollow particles used in the present disclosure preferably have a solid shell.

From the viewpoint of exerting excellent dielectric property, the hollow portion of the hollow particles used in the present disclosure is preferably filled with gas such as air.

The hollow particles used in the present disclosure may have one hollow portion or two or more hollow portions. From the viewpoint of maintaining good balance between the high void ratio and the mechanical strength and from the viewpoint of improving the dielectric property, the hollow particles preferably have only one or two hollow portions, and more preferably have only one hollow portion. In the hollow particles used in the present disclosure, the percentage of the number of the particles having only one or two hollow portions is preferably 90% or more, and more preferably 95% or more. Also, the percentage of the number of the particles having only one hollow portion is preferably 90% or more, and more preferably 95% or more.

The shell of the hollow particles used in the present disclosure and, when the hollow particles have two or more hollow portions, a partition separating the adjacent hollow portions from each other may be porous. From the viewpoint of improving the dielectric property, the shell and the partition are preferably solid.

The shape of the hollow particles used in the present disclosure may be a spherical shape, an ellipsoidal shape or an irregular shape, for example. From the viewpoint of the dielectric property, dispersibility and pressure resistance of the hollow particles, the shape is preferably a spherical shape.

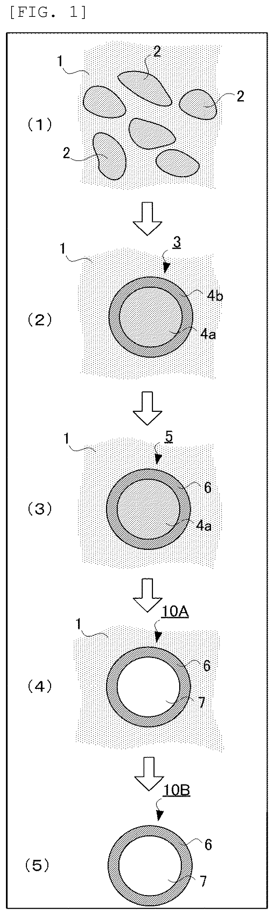

An example of the image of the shape of the hollow particles used in the present disclosure, is a bag which is made of a thin film and inflated with gas. A cross-section of the bag is like the hollow particle 10B shown in the diagram (5) of FIG. 1. In this example, one thin film is provided on the outside, and the interior is filled with gas.

The hollow portion of the hollow particles can be determined by, for example, SEM observation of a cross section of the particles or TEM observation of the particles as they are. The shape of the particles can be determined by SEM or TEM observation of the hollow particles, for example.

The hollow particles used in the present disclosure may contain, as impurities, small amounts of particles having a low circularity, such as cracked or deformed particles. From the viewpoint of dielectric property, in 100% by mass of the hollow particles, the percentage of the particles having a circularity of 0.85 or less is preferably 10% by mass or less, more preferably 7% by mass or less, and still more preferably 4% by mass or less.

The particles having a circularity of 0.85 or less are typically cracked particles or deformed particles such as dented particles. In the present disclosure, such particles may be referred to as "irregular-shaped particles". Such irregular-shaped hollow particles have a low void ratio compared to spherical hollow particles; therefore, they are poor in dielectric property. Accordingly, the dielectric property of the hollow particles can be improved by decreasing the percentage of the irregular-shaped particles included in the hollow particles. Also, the irregular-shaped particles have the following problem: compared to spherical particles, the irregular-shaped particles are poor in dispersibility since they are likely to aggregate when dispersed in the matrix resin. In addition, such irregular-shaped particles have the following problem: they are poor in pressure resistance compared to spherical particles, since external pressure is likely to be locally applied thereto. When the irregular-shaped particles are dispersed in the matrix resin, aggregates are likely to be formed; external pressure is likely to be applied to the aggregates; and the pressure resistance further deteriorates, accordingly.

Therefore, the dispersibility and pressure resistance of the hollow particles can be improved by decreasing the percentage of the irregular-shaped particles included in the hollow particles.

The term "circularity" is defined as a value obtained by dividing the equivalent circular area diameter which is the diameter of a circle having the same area as the projected image of a particle, by the equivalent circular perimeter diameter which is the diameter of a circle having the same perimeter as the projected image of the particle. The circularity is 1 when the hollow particles are perfectly spherical, and it gets smaller as the surface shape of the hollow particles is more complex.

The average circularity of the hollow particles used in the present disclosure may be from 0.950 to 0.995.

In the present disclosure, the circularity is measured by use of a flow particle image analyzer at an image resolution of 0.185 um/pixel.

As the flow particle image analyzer, for example, IF-3200 (product name, manufactured by JASCO International Co., Ltd.) is preferably used. The measurement sample is prepared by, for example, performing a dispersion treatment of a mixture liquid, which is obtained by adding 0.10 g to 0.12 g of the hollow particles to an aqueous solution of linear alkylbenzene sulfonate (concentration 0.3%), in an ultrasonic cleaner for 5 minutes.

The average circularity is the average of the circularities of randomly selected 1000 to 3000 particles.

The void ratio of the hollow particles used in the present disclosure is 55% or more. Accordingly, the hollow particles are excellent in dielectric property, and they are also excellent in lightness in weight, heat insulation and so on. The void ratio of the hollow particles used in the present disclosure is preferably 60% or more, and more preferably 65% or more.

The upper limit of the void ratio of the hollow particles is not particularly limited. From the viewpoint of suppressing a decrease in the strength of the hollow particles and improving the collapse-resistance of the hollow particles, the void ratio is preferably 90% or less, more preferably 85% or less, and still more preferably 80% or less.

The void ratio of the hollow particles can be calculated from the apparent density $D_1$ and true density $D_0$ of the hollow particles.

A method for measuring the apparent density $D_1$ of the hollow particles is as follows. First, approximately 30 cm³ of the hollow particles are introduced into a measuring flask with a volume of 100 cm³, and the mass of the introduced hollow particles is precisely weighed. Next, the measuring flask in which the hollow particles are introduced, is precisely filled with isopropanol up to the marked line while care is taken so that air bubbles do not get in. The mass of the isopropanol added to the measuring flask is precisely weighed, and the apparent density $D_1$ (g/cm³) of the hollow particles is calculated by the following formula (I).

```
Apparent density D₁

= [Mass of the hollow particles] / (100 - [Mass of the isopropanol] / [Specific gravity of the isopropanol at the

measuring temperature])    Formula (I)
```

The apparent density $D_1$ is equivalent to the specific gravity of the whole hollow particle in the case where the hollow portion is regarded as a part of the hollow particle.

A method for measuring the true density $D_0$ of the hollow particles is as follows. The hollow particles are pulverized in advance; approximately 10 g of the pulverized hollow particles are introduced into a measuring flask with a volume of 100 cm³; and the mass of the introduced pulverized particles is precisely weighed. After that, similarly to the measurement of the apparent density mentioned above, isopropanol is added to the measuring flask; the mass of the isopropanol is precisely weighed; and the true density $D_0$ (g/cm³) of the hollow particles is calculated by the following formula (II).

True density $D_0$ = [Mass of the pulverized hollow particles]/ (100 - [Mass of the isopropanol] / [Specific gravity of the isopropanol at the measuring temperature])    Formula (II)

The true density $D_0$ is equivalent to the specific gravity of the shell portion alone of the hollow particle. As is clear from the measurement method mentioned above, when calculating the true density $D_0$, the hollow portion is not regarded as a part of the hollow particle.

The void ratio (%) of the hollow particles is calculated by the following formula (III) from the apparent density $D_1$ and the true density $D_0$.

Void ratio (%) = 100 - (Apparent density $D_1$ / True density $D_0$) $\times$ 100    Formula (III)

The volume average particle diameter of the hollow particles used in the present disclosure is not particularly limited. Since the pressure resistance is improved, and since the aggregability of the hollow particles decreases and, as a result, the hollow particles exert excellent dispersibility, the volume average particle diameter of the hollow particles is preferably 0.1 μm or more, more preferably 0.5 μm or more, and still more preferably 1 μm or more as the lower limit. On the other hand, it is preferably 10 μm or less, more preferably 8 μm or less, and still more preferably 5 μm or less as the upper limit. When the volume average particle diameter of the hollow particles is equal to or less than the upper limit value, since the particle diameter is sufficiently small, the hollow particles are preferably used as a material of a substrate such as an electronic circuit board, and they can be added to thin small substrates.

The particle size distribution (volume average particle diameter (Dv) / number average particle diameter (Dn)) of the hollow particles is not particularly limited. It is preferably 1.1 or more and 2.5 or less, and more preferably 1.1 or more and 2.0 or less. When the particle size distribution is equal to or less than the upper limit value, the dielectric property tends to be excellent, and hollow particles such that performance slightly vary between the hollow particles, can be obtained. Also when the particle size distribution is equal to or less than the upper limit value, a product having uniform thickness can be produced in the case of producing, for example, a sheet-shaped structure by use of the resin composition of the present disclosure.

The volume average particle diameter (Dv) and number average particle diameter (Dn) of the hollow particles can be found as follows, for example. The particle diameter of the hollow particles is measured with a particle size distribution measuring device by the Coulter counter method; the number average and volume average of the particle diameters are calculated; and the obtained values can be used as the number average particle diameter (Dn) and volume average particle diameter (Dv) of the hollow particles. The particle size distribution is found by dividing the volume average particle diameter by the number average particle diameter. The Coulter counter method is a method for measuring the diameter of particles by the electric resistance method called the Coulter Principle.

The dielectric dissipation factor of the hollow particles used in the present disclosure at a frequency of 10 GHz, is preferably $1.0 \times 10^{-3}$ or less, more preferably $8.0 \times 10^{-4}$ or less, and still more preferably $6.0 \times 10^{-4}$ or less. The lower limit of the dielectric dissipation factor is not particularly limited. For example, it may be $1.00 \times 10^{-4}$ or more.

The relative permittivity of the hollow particles used in the present disclosure at a frequency of 10 GHz, is preferably 1.50 or less, more preferably 1.47 or less, still more preferably 1.45 or less, and even more preferably 1.40 or less. The lower limit of the relative permittivity is not particularly limited, and it may be 1.00 or more, for example.

In the present disclosure, the relative permittivity and dielectric dissipation factor of the hollow particles are measured by use of a perturbation-type measuring device.

The thermal expansion coefficient at 23°C to 100°C of the hollow particles used in the present disclosure, is preferably $1.0 \times 10^{-4}$/°C or less, more preferably $8.0 \times 10^{-5}$/°C or less, and still more preferably $6.0 \times 10^{-5}$/°C or less. The lower limit of the thermal expansion coefficient is not particularly limited, and it is generally $1.0 \times 10^{-5}$/°C or more.

In the present disclosure, the thermal expansion coefficient $\alpha_p$ of the hollow particles can be obtained by the following formula (IV):

$$\alpha_p = (\alpha_c - SG_r \times \alpha_r) / W_p \quad \text{Formula (IV)}$$

(where $\alpha_c$ is the thermal expansion coefficient of a plate formed of the matrix resin and the hollow particles; $\alpha_r$ is the thermal expansion coefficient of the matrix resin alone; $SG_r$ is the volume ratio of the matrix resin of the formed plate; and $W_p$ is the volume ratio of the hollow particles in the formed plate.)

In accordance with JIS K7197:2012, the thermal expansion coefficient is measured in a predetermined temperature range.

As the matrix resin used for the thermal expansion coefficient, for example, epoxy resin is used.

The thermal decomposition initiation temperature of the hollow particles used in the present disclosure is preferably 345°C or more, and more preferably 350°C or more. When the thermal decomposition initiation temperature is equal to or more than the lower limit value, the hollow particles are excellent in heat resistance. The upper limit of the thermal decomposition initiation temperature of the hollow particles is not particularly limited. For example, it may be 400°C or less.

In the present disclosure, the thermal decomposition initiation temperature of the hollow particles can be measured as a 5% weight reduction temperature, using a TG-DTA device in a nitrogen atmosphere, in the condition of a nitrogen flow rate of 230 mL/min and a temperature increase rate of 10°C/min.

The electric conductivity of an aqueous dispersion of the hollow particles used in the present disclosure, in which the hollow particles in a volumetric amount of 0.35 cm³ are dispersed in 100 mL of deionized water, is preferably 30 μS/cm or less.

In the aqueous dispersion obtained by dispersing the hollow particles in the deionized water, the electric conductivity tends to increase as the amount of the metal or ionic surfactant eluted from the hollow particles increases. It is estimated that the metal and ionic surfactant eluted from the hollow particles into the aqueous dispersion are attached to the particle surface while being in a state where they can be easily released from the hollow particles, and the metal and ionic surfactant are attached to the particle surface when the particles are in a dry state. Accordingly, the electric conductivity of the aqueous dispersion can be used as the index of the amount of the metal and ionic surfactant attached to the surface of the hollow particles in a dry state.

If the metal is attached to the particle surface, the particles are subjected to polarization when an electric field is applied; therefore, the dielectric dissipation factor of the particles is increased. If the surfactant is attached to the particle surface, water in the air is likely to be absorbed, and the dielectric dissipation factor of the particles is increased by the water attached to the particle surface.

Also, when the amount of the metal and ionic surfactant eluted from the hollow particles into the aqueous dispersion increase, ion migration is likely to occur on the electronic circuit board containing the hollow particles. It is estimated that when the metal or surfactant is attached to the surface of the hollow particles, on an electronic circuit board in which the hollow particles are contained in an insulating resin layer, the metal or surfactant absorbs water and is likely to be ionized in high-humidity environment; a dendrite is likely to be generated; and ion migration is likely to occur, accordingly. When, among surfactants, the ionic surfactant is attached to the surface of the hollow particles, since a large amount of ionic component is contained in the surfactant, metal ionization is further promoted, and ion migration is more likely to occur, accordingly.

From the viewpoint of the dielectric property and the reliability, the electric conductivity of the aqueous dispersion of the hollow particles is more preferably 25 $\mu$S/cm or less, still more preferably 20 $\mu$S/cm or less, even more preferably 15 $\mu$S/cm or less, and particularly preferably 11 $\mu$S/cm or less. The lower limit of the electric conductivity is not particularly limited. For example, it may be 0.5 $\mu$S/cm or more.

In the present disclosure, the aqueous dispersion of the hollow particles subjected to electric conductivity measurement may further contain a dispersant, as long as the electric conductivity is 2 $\mu$S/cm or less in the absence of the hollow particles. The type and content of the dispersant is appropriately adjusted so that the hollow particles are uniformly dispersed. The aqueous dispersion of the hollow particles subjected to electric conductivity measurement is found to be in such a state by visual confirmation, that powder (the hollow particles) is not present in the upper part and is entirely dispersed in the water.

As the dispersant that can be used in the aqueous dispersion of the hollow particles for electric conductivity measurement, such a dispersant can be appropriately selected and used, that when added to deionized water, it does not cause a change in the pH or electric conductivity of the deionized water. For example, a non-ionic surfactant can be used.

The non-ionic surfactant is not particularly limited, and it can be selected from known non-ionic surfactants and used. As the non-ionic surfactant, examples include, but are not limited to, a polyoxyalkylene-type non-ionic surfactant such as a higher alcohol alkylene oxide adduct, an alkylphenol alkylene oxide adduct, a fatty acid alkylene oxide adduct, a higher alkylamine alkylene oxide adduct, a polyhydric alcohol aliphatic ester alkylene oxide adduct, a polypropylene glycol ethylene oxide adduct, a fatty acid amide alkylene oxide adduct, and a polyoxyalkylene styrenated phenyl ether; a polyhydric alcohol-type non-ionic surfactant such as a polyethylene oxide, a fatty acid ester of glycerin, an alkyl glycoxide, a fatty acid ester of pentaerythritol, a fatty acid ester of sorbit or sorbitan, a sucrose fatty acid ester, an alkyl ether of polyhydric alcohol, and an aliphatic amide of alkanolamine; and a non-ionic polymer compound containing both a hydrophilic group and a hydrophobic group, such as polyvinyl alcohol and polyvinylpyrrolidone. Of them, a polyoxyalkylene-type non-ionic surfactant is preferably used.

In the aqueous dispersion of the hollow particles, the concentration of the non-ionic surfactant is not particularly limited. For example, it can be from 0.05% by mass to 1% by mass.

Also in the present disclosure, the hollow particles added to the aqueous dispersion used for electric conductivity measurement, are hollow particles just before being added to the resin composition.

In the present disclosure, as the hollow particles with a volume of 0.35 cm$^3$, hollow particles having the weight (g) obtained by the following formula (V) are weighed out, collected and used. In the following formula (V), the apparent density $D_1$ of the hollow particles is the same as the apparent density $D_1$ of the hollow particles measured to obtain the void ratio described below.

Weight (g) of the hollow particles with a volume of 0.35 cm$^3$ = Apparent density $D_1$ (g/cm$^3$) of the hollow particles $\times$ 0.35 (cm$^3$)　　　　Formula (V)

In the hollow particles used in the present disclosure, the content of the metal is preferably 100 ppm or less, more preferably 70 ppm or less, still more preferably 50 ppm or less, even more preferably 40 ppm or less, and particularly preferably 30 ppm or less. The metal content is the ratio of the total mass of the metal components contained in the hollow particles to the mass of the hollow particles. Since the metal contained in the hollow particles used in the present disclosure is generally derived from the dispersion stabilizer, the metal content can be adjusted to the upper limit value or less by sufficiently removing the dispersion stabilizer from the hollow particles.

When the metal content in the hollow particles is equal to or less than the upper limit value, the dielectric property and the reliability can be improved; moreover, the drying time can be shortened in the below-described drying step.

The metal content in the hollow particles can be measured by ICP atomic emission spectroscopy. The metal species can be specified by X-ray fluorescence spectrometry (XRF). In this method, the measurement limit of the metal content in the hollow particles is generally 5 ppm.

In the hollow particles used in the present disclosure, the total content of the surfactant and water-soluble polymer stabilizer (hereinafter, they are simply referred to as "surfactant and so on") present on the particle surface is preferably 500 ppm or less, more preferably 200 ppm or less, still more preferably 100 ppm or less, and even more preferably 50 ppm or less. The water-soluble polymer stabilizer may be an organic or inorganic water-soluble polymer stabilizer. When the content of the surfactant and so on present on the surface of the hollow particles, is equal to or less than the upper limit value, the dielectric property and the reliability tend to improve. By using only the inorganic dispersion stabilizer as the dispersion stabilizer in the below-described process of producing the hollow particles, the content of the surfactant and so on present on the surface of the hollow particles can be adjusted to less than the measurement limit value.

In the present disclosure, the content of the surfactant and so on present on the surface of the hollow particles is the ratio of the mass of the surfactant and so on present on the surface of the hollow particles to the mass of the hollow particles. The surfactant and so on present on the surface of the hollow particles can be extracted by, for example, ultrasonic treatment of the hollow particles in water. The type and mass of the surfactant and so on extracted into water can be identified by the peak position and peak intensity of a $^1$H-NMR spectrum. In this method, the measuring limit of the amount of the surfactant and so on present on the surface of the hollow particles, is generally 0.05 ppm.

Examples of Patent Document 1 show that the adhesion between the insulation layer of the metal foil-clad laminate and the metal foil is increased by adding the hollow particles to the insulation layer. However, when the metal foil-clad laminate is produced by use of the resin composition disclosed in Patent Document 1, the adhesion between the insulation layer and the metal foil may be insufficient. Since the hollow particles disclosed in Patent Document 1 are produced by use of the surfactant, the surfactant may remain on the particle surface. When the surfactant remains on the particle surface, the interface between the hollow particles and the matrix resin are likely to be peeled off; therefore, a problem such as the insufficient adhesion between the insulation layer and the metal foil is likely to occur, and the reliability deteriorates.

The resin contained in the shell of the hollow particles used in the present disclosure is typically the polymer of the polymerizable monomer used in the hollow particle production method described below. To the extent that does not impair the effects of the present disclosure, the shell may further contain an additive which is different from the resin. In the case of containing the additive, the content of the resin in the shell is preferably 96% by mass or more, more preferably 97% by mass or more, still more preferably 98% by mass or more, and even more preferably 99% by mass or more.

In the resin composition of the present disclosure, the content of the hollow particles is not particularly limited. In 100% by mass of the total solid content of the resin composition, the content of the hollow particles is preferably 5% by mass or more, and more preferably 10% by mass or more as the lower limit. On the other hand, the content of the hollow particles is preferably 50% by mass or less, more preferably 30% by mass or less, still more preferably 20% by mass or less, and even more preferably 15% by mass or less as the upper limit. When the content of the hollow particles is equal to or more than the lower limit value, excellent effects are exerted by the hollow particles, such as the effect of decreasing the dielectric dissipation factor, permittivity and weight of the resin composition and the effect of heat insulation. When the content of the hollow particles is equal to or less than the upper limit value, the matrix resin can be sufficiently contained in the resin composition; therefore, a deterioration in the properties of the resin composition can be suppressed, and the mechanical properties can be improved.

[Method for producing the hollow particles]

The hollow particles used in the present disclosure are produced by, for example, the production method described below, which is based on the suspension polymerization method.

For example, an embodiment of the method for producing the hollow particles used in the present disclosure is a hollow particle production method comprising:

preparing a mixture liquid containing a polymerizable monomer, a hydrophobic solvent, a polymerization initiator, a dispersion stabilizer and an aqueous medium,

suspending the mixture liquid to prepare a suspension in which droplets of a monomer composition containing the polymerizable monomer, the hydrophobic solvent and the polymerization initiator are dispersed in the aqueous medium,

subjecting the suspension to a polymerization reaction to prepare a precursor composition in which precursor particles comprising a shell, which contains a resin, and a hollow portion surrounded by the shell and filled with the hydrophobic solvent, are dispersed in the aqueous medium,
removing the hydrophobic solvent from the precursor particles to obtain an aqueous dispersion of the hollow particles, by bubbling a gas into the precursor composition while stirring the precursor composition in a stirring tank, and
washing the hollow particles for removal of the dispersion stabilizer remaining therein.

In the present disclosure, the hollow particles having the hollow portion filled with the hydrophobic solvent, may be considered as the intermediate of the hollow particles in which the hollow portion is filled with gas, and they may be referred to as the "precursor particles". Also in the present disclosure, the "precursor composition" means a composition containing the precursor particles.

In the production method, by suspending the mixture liquid containing the polymerizable monomer, the hydrophobic solvent, the polymerization initiator, the dispersion stabilizer and the aqueous medium, phase separation occurs between the polymerizable monomer and the hydrophobic solvent. Accordingly, the suspension in which the droplets of the monomer composition are dispersed in the aqueous medium is prepared, the droplets having a distribution structure such that the polymerizable monomer is distributed on the surface side and the hydrophobic solvent is distributed in the center. By subjecting the suspension to a polymerization reaction, a polymer starts to precipitate on the surface of the droplets of the monomer composition, and the polymerization reaction is further developed. Accordingly, the surface of the droplets is cured to form the shell, thereby obtaining the hollow particles having the hollow portion filled with the hydrophobic solvent.

The reactive unsaturated bond can be introduced to the shell surface by incorporating the crosslinkable monomer in the mixture liquid or by adding the crosslinkable monomer to the suspension during the polymerization reaction to further continue the polymerization reaction.

In the above production method, after the hydrophobic solvent is removed from the precursor particles in the slurry, the hollow particles are washed for removal of the dispersion stabilizer; therefore, the hydrophobic solvent is removed from the hollow particles before the washing step, and the residual unreacted polymerizable monomer is removed, accordingly. The hollow particles are likely to aggregate when the content of the hydrophobic solvent and unreacted polymerizable monomer in the aqueous dispersion of the hollow particles is large. In the above production method, however, due to the removal of the hydrophobic solvent and the unreacted polymerizable monomer before the washing step, the hollow particles are less likely to aggregate during the washing step; the particles can be thoroughly washed; and as a result, the washability is improved.

The above-described production method includes the steps of preparing the mixture liquid, preparing the suspension, subjecting the suspension to a polymerization reaction, removing the hydrophobic solvent from the precursor particles, and washing the hollow particles for removal of the dispersion stabilizer. The method may further include other steps. As far as technically possible, two or more of the above steps and other additional steps may be simultaneously carried out as one step, or their order may be changed and then they may be carried out in that order. For example, the preparation and suspension of the mixture liquid may be simultaneously carried out in one step (for example, the mixture liquid may be suspended while adding the materials for the mixture liquid).

A preferred embodiment of the method for producing the hollow particles used in the present disclosure, may be a production method including the following steps.

(1) Mixture liquid preparation step

The mixture liquid preparation step includes preparing a mixture liquid containing a polymerizable monomer, a hydrophobic solvent, a polymerization initiator, a dispersion stabilizer and an aqueous medium.

(2) Suspension step

The suspension step includes suspending the mixture liquid to prepare a suspension in which droplets of a monomer composition containing the polymerizable monomer, the hydrophobic solvent and the polymerization initiator are dispersed in the aqueous medium.

(3) Polymerization step

The polymerization step includes subjecting the suspension to a polymerization reaction to prepare a precursor composition in which precursor particles comprising a shell, which contains a resin, and a hollow portion surrounded by the shell and filled with the hydrophobic solvent, are dispersed in the aqueous medium.

(4) Solvent removal step

The solvent removal step includes removing the hydrophobic solvent from the precursor particles to obtain an aqueous dispersion of the hollow particles, by bubbling a gas into the precursor composition while stirring the precursor composition in a stirring tank.

(5) Washing step

The washing step includes washing the hollow particles for removal of the dispersion stabilizer remaining therein.

FIG. 1 is a schematic diagram showing an example of the production method of the present disclosure. The diagrams (1) to (5) in FIG. 1 correspond to the steps (1) to (5) described above, respectively. White arrows between the diagrams indicate the order of the steps. FIG. 1 is merely a schematic diagram for description, and the production method of the present disclosure is not limited to the method shown in FIG. 1. Further, the structures, dimensions and shapes of materials used for the production method of the present disclosure are not limited to the structures, dimensions and shapes of various materials shown in these diagrams.

The diagram (1) of FIG. 1 is a schematic cross-sectional view showing an embodiment of the mixture liquid in the mixture liquid preparation step. As shown in the diagram, the mixture liquid contains an aqueous medium 1 and a low polarity material 2 dispersed in the aqueous medium 1. Here, the low polarity material 2 means a material that has low polarity and is less likely to mix with the aqueous medium 1. In the present disclosure, the low polarity material 2 contains the polymerizable monomer, the hydrophobic solvent and the polymerization initiator.

The diagram (2) of FIG. 1 is a schematic cross-sectional view showing an embodiment of the suspension in the suspension step. The suspension contains the aqueous medium 1 and droplets 3 of the monomer composition dispersed in the aqueous medium 1. The droplets 3 of the monomer composition contain the polymerizable monomer, the hydrophobic solvent and the polymerization initiator, and their distribution in the droplets is not uniform. The droplets 3 of the monomer composition have the following structure: phase separation occurs between a hydrophobic solvent 4a and a material 4b containing the polymerizable monomer and not containing the hydrophobic solvent; the hydrophobic solvent 4a is distributed in the center; the material 4b not containing the hydrophobic solvent is distributed on the surface side; and the dispersion stabilizer (not shown) is on the surface.

The diagram (3) of FIG. 1 is a schematic cross-sectional view showing an embodiment of the precursor composition obtained by the polymerization step, which contains the precursor particles which include the hydrophobic solvent in the hollow portion. Precursor particles 5 comprise a shell 6, which contains a resin, and a hollow portion, which is filled with the hydrophobic solvent 4a. The shell 6 forming the outer surface of the precursor particles 5 is formed by polymerization of the polymerizable monomer contained in the droplets 3 of the monomer composition, and it may be the crosslinkable monomer added and further polymerized during the polymerization reaction. In the diagram (3) of FIG. 1, the precursor particles 5 are dispersed in the aqueous medium 1.

The diagram (4) of FIG. 1 is a schematic cross-sectional view showing an embodiment of the aqueous dispersion of the hollow particles obtained in the solvent removal step. In the solvent removal step, hollow particles 10A comprising a resin-containing shell 6 and a gas-filled hollow portion 7 are obtained by removing the hydrophobic solvent from the precursor particles. In the diagram (4) of FIG. 1, the hollow particles 10A are dispersed in the aqueous medium 1.

The diagram (5) of FIG. 1 is a schematic cross-sectional view showing an embodiment of the hollow particles after the washing step. In hollow particles 10B after the washing step, generally, the residual polymerizable monomer amount and the residual metal amount are decreased compared to the hollow particles 10A before the washing step.

Hereinafter, the five steps described above and other steps will be described in order.

(1) Mixture liquid preparation step

The mixture liquid preparation step includes preparing a mixture liquid containing a polymerizable monomer, a hydrophobic solvent, a polymerization initiator, a dispersion stabilizer and an aqueous medium. The mixture liquid may further contain other materials to the extent that does not impair the effects of the present disclosure.

The materials for the mixture liquid will be described in the following order: (A) the polymerizable monomer, (B) the hydrophobic solvent, (C) the polymerization initiator, (D) the dispersion stabilizer and (E) the aqueous medium.

(A) Polymerizable monomer

In the present disclosure, the polymerizable monomer is a compound containing an addition-polymerizable functional group (in the present disclosure, it may be simply referred to as "polymerizable functional group"). In the present disclosure, as the polymerizable monomer, a compound which contains an ethylenically unsaturated bond as the addition-polymerizable functional group, is generally used. The polymerizable functional group is preferably a radically polymerizable group. From the viewpoint of excellent reactivity, the polymerizable functional group is preferably at least one selected from the group consisting of a (meth)acryloyl group, a vinyl group and an allyl group, and more preferably at least one selected from the group consisting of a (meth)acryloyl group and a vinyl group.

In the present disclosure, a polymerizable monomer which has only one polymerizable functional group is referred to as a non-crosslinkable monomer, and a polymerizable monomer which has two or more polymerizable functional groups is referred to as a crosslinkable monomer. The crosslinkable monomer can form crosslinking in the polymer by polymerization reaction. The crosslinkable monomer becomes a crosslinkable monomer unit in the shell, and the non-crosslinkable monomer becomes a non-crosslinkable monomer unit in the shell.

Also in the present disclosure, a polymerizable monomer composed of the elements carbon and hydrogen is referred to as "hydrocarbon monomer"; a crosslinkable monomer composed of the elements carbon and hydrogen is referred to as "crosslinkable hydrocarbon monomer"; and a non-crosslinkable monomer composed of the elements carbon and hydrogen is referred to as "non-crosslinkable hydrocarbon monomer". Also in the present disclosure, a polymerizable monomer containing a (meth)acryloyl group as a polymerizable functional group is referred to as "acrylic monomer"; a crosslinkable monomer containing a (meth)acryloyl group as a polymerizable functional group is referred to as "crosslinkable acrylic monomer"; and a non-crosslinkable monomer containing a (meth)acryloyl group as a polymerizable functional group is referred to as "non-crosslinkable acrylic monomer". In the crosslinkable acrylic monomer, at least one polymerizable functional group is only required to be a (meth)acryloyl group, and all polymerizable functional groups are preferably (meth)acryloyl groups.

Also in the present disclosure, (meth)acrylate means each of acrylate and methacrylate; (meth)acryl means each of acryl and methacryl; and (meth)acryloyl means each of acryloyl and methacryloyl.

In the present disclosure, the reactive unsaturated bond can be introduced onto the shell surface by containing the crosslinkable monomer as the polymerizable monomer.

When the crosslinkable monomer is contained as the polymerizable monomer, in the polymerization reaction of the suspension, the crosslinking density of the polymer precipitated on the surface of the droplets increases, and the precipitates are crosslinked. Accordingly, the crosslinking density of the shell can be increased. As a result, the shell excellent in strength is easily formed; the thus-obtained hollow particles tend to be spherical; and the hollow portion that is clearly distinguished from the shell is easily formed in the interior of the particles.

From the viewpoint of improving the dielectric property of the hollow particles, more preferably, the crosslinkable monomer and the non-crosslinkable monomer are contained as the polymerizable monomer.

As the crosslinkable monomer, examples include, but are not limited to, the following: a crosslinkable hydrocarbon monomer such as an aromatic divinyl monomer (e.g., divinylbenzene, divinylbiphenyl and divinylnaphthalene), a diene monomer (e.g., a linear or branched diolefin such as butadiene, isoprene, 2,3-dimethylbutadiene, pentadiene and hexadiene, and an alicyclic diolefin such as dicyclopentadiene, cyclopentadiene and ethylidene tetracyclododecene) and a crosslinkable macromer (e.g., a polybutadiene, a polyisoprene, a styrene-butadiene block copolymer (SBS) and a styrene-isoprene block copolymer (SIS)); a crosslinkable acrylic monomer such as allyl (meth)acrylate, vinyl (meth)acrylate, ethylene glycol di(meth)acrylate, diethylene glycol di(meth)acrylate, pentaerythritol di(meth)acrylate, tricyclodecane dimethanol di(meth)acrylate, 3-(meth)acryloyloxy-2-hydroxypropyl (meth)acrylate, 1,3-bis(methacryloyloxy)-2-hydroxypropane, trimethylolpropane tri(meth)acrylate, ditrimethylolpropane tetra(meth)acrylate, pentaerythritol tri(meth)acrylate, pentaerythritol tetra(meth)acrylate, dipentaerythritol hexa (meth) acrylate, dipentaerythritol poly (meth) acrylate, 1,6-hexanediol di(meth)acrylate, 1,9-nonanediol di(meth)acrylate, 1,10-decanediol di(meth)acrylate, neopentyl glycol di(meth)acrylate, polyethylene glycol di(meth)acrylate, polypropylene glycol di(meth)acrylate and bisphenol A di(meth) acrylate, and ethoxylates thereof; a crosslinkable allyl monomer such as diallyl phthalate; and a crosslinkable macromer such as both-vinyl-terminated polyphenylene ether and both-(meth)acrylic-terminated polyphenylene ether.

These crosslinkable monomers may be used alone or in combination of two or more.

From the viewpoint of decreasing the dielectric dissipation factor of the hollow particles, a crosslinkable hydrocarbon monomer is preferably contained as the crosslinkable monomer. Among crosslinkable hydrocarbon monomers, from the point of view that the reactive unsaturated bond can be easily introduced onto the shell surface, an aromatic divinyl monomer is preferred, and a divinylbenzene is particularly preferred. Among divinylbenzenes, at least one selected from the group consisting of m-divinylbenzene and p-divinylbenzene is preferred, without particular limitation.

As the non-crosslinkable monomer, examples include, but are not limited to, the following: a non-crosslinkable hydrocarbon monomer such as an aromatic monovinyl monomer (e.g., styrene, vinyl toluene, $\alpha$-methylstyrene, p-methylstyrene, ethylvinylbenzene, ethylvinylbiphenyl and ethylvinylnaphthalene), a linear or branched monoolefin (e.g., ethylene, propylene and butylene) and an alicyclic monoolefin (e.g., vinylcyclohexane, norbornene, tricyclododecene and 1,4-methano-1,4,4a,9a-tetrahydrofluorene); a non-crosslinkable acrylic monomer such as methyl (meth)acrylate, ethyl (meth)acrylate, butyl (meth)acrylate, 2-ethylhexyl (meth)acrylate, lauryl (meth)acrylate), t-butylaminoethyl (meth)acrylate, glycidyl (meth)acrylate, 2-hydroxyethyl (meth)acrylate, 2-aminoethyl (meth)acrylate, (meth)acrylic acid, (meth)acrylamide, N-methylol (meth)acrylamide, N-butoxymethyl (meth)acrylamide, methoxypolyethylene glycol (meth)acrylate, ethoxypolyethylene glycol (meth)acrylate, propoxypolyethylene glycol (meth)acrylate, butoxypolyethylene glycol (meth)acrylate, hexaoxypolyethylene glycol (meth)acrylate, octoxypolyethylene glycol polypropylene glycol (meth)acrylate, lauroxypolyethylene glycol (meth)acrylate, stearoxypolyethylene glycol (meth)acrylate, phenoxypolyethylene glycol polypropylene glycol (meth)acrylate, polyethylene glycol mono(meth)acrylate, polypropylene glycol mono(meth)acrylate, polyethylene glycol propylene glycol mono(meth)acrylate, polyethylene glycol tetramethylene glycol (meth)acrylate, propylene glycol polybutylene glycol mono (meth) acrylate, and monoethylene glycol mono(meth)acrylate; a carboxylic acid vinyl ester monomer such as vinyl acetate; a halogenated aromatic vinyl monomer such as halogenated styrene; a vinyl halide monomer such as vinyl chloride; a vinylidene halide monomer such as vinylidene chloride; vinylpyridine; and a non-crosslinkable macromer such as (meth)acrylic-terminated polystyrene and (meth)acrylic-terminated polymethyl methacrylate.

These non-crosslinkable monomers may be used alone or in combination of two or more.

Especially from the viewpoint of decreasing the dielectric dissipation factor of the hollow particles, the non-crosslinkable monomer is preferably a non-crosslinkable hydrocarbon monomer, more preferably an aromatic monovinyl monomer, and still more preferably styrene and ethylvinylbenzene.

The content of the polymerizable monomer in the mixture liquid is not particularly limited. From the viewpoint of the balance of the void ratio, particle diameter and mechanical strength of the hollow particles, with respect to the total mass (100% by mass) of the components (except for the aqueous medium) in the mixture liquid, the content of the polymerizable monomer is preferably from 15% by mass to 50% by mass, and more preferably from 20% by mass to 40% by mass.

From the viewpoint of suppressing a deterioration in the dielectric property of the obtained hollow particles and a decrease in the strength thereof, the content of the polymerizable monomer is preferably 96% by mass or more, and more preferably 97% by mass or more, with respect to the total mass (100% by mass) of a solid content obtained by excluding the hydrophobic solvent from the material for the oil phase in the mixture liquid.

In the present disclosure, the solid content includes all components excluding solvent, and a liquid polymerizable monomer and the like are included in the solid content.

(B) Hydrophobic solvent

The hydrophobic solvent used in the production method of the present disclosure is a non-polymerizable, sparingly water-soluble organic solvent.

The hydrophobic solvent serves as a spacer material for forming the hollow portion in the interior of the particles. In the suspension step described later, the suspension in which the droplets of the monomer composition containing the hydrophobic solvent are dispersed in the aqueous medium, is obtained. In the suspension step, phase separation occurs in the droplets of the monomer composition. As a result, the hydrophobic solvent with low polarity is likely to collect in the interior of the droplets of the monomer composition. In the end, according to their respective polarities, the hydrophobic solvent is distributed in the interior of the droplets of the monomer composition, and the material not containing the hydrophobic solvent is distributed at the periphery of the droplets of the monomer composition.

Then, in the polymerization step described later, an aqueous dispersion containing the precursor particles including the hydrophobic solvent, is obtained. That is, since the hydrophobic solvent collects in the interior of the particles, the hollow portion filled with the hydrophobic solvent is formed in the interior of the obtained precursor particles.

The hydrophobic solvent can be appropriately selected from the group consisting of known hydrophobic solvents, without particular limitation. As the hydrophobic solvent, examples include, but are not limited to, an ester such as ethyl acetate and butyl acetate; an ether ester such as propylene glycol monomethyl ether acetate and propylene glycol monoethyl ether acetate; and a hydrocarbon solvent. Of them, a hydrocarbon solvent is preferred, and a hydrocarbon solvent containing 5 to 8 carbon atoms is more preferred.

As the hydrocarbon solvent, examples include, but are not limited to, an aromatic hydrocarbon solvent such as benzene, toluene and xylene, and aliphatic hydrocarbons including a chain hydrocarbon solvent such as pentane, hexane, heptane, octane, 2-methylbutane, 2-methylpentane and a paraffin-based solvent, and a cyclic hydrocarbon solvent such as cyclohexane, methylcyclohexane and cycloheptane.

These hydrophobic solvents may be used alone or in combination of two or more.

From the point of view that phase separation is likely to occur between the polymerizable monomer and hydrophobic solvent in the droplets of the monomer composition during the suspension step, such an organic solvent is preferably selected as the hydrophobic solvent, that the water solubility of the organic solvent is smaller than that of the crosslinkable monomer contained in the polymerizable monomer.

When the polymerizable monomer contains the hydrocarbon monomer in an amount of more than 50% by mass, the hydrophobic solvent is preferably a hydrocarbon solvent, more preferably a chain hydrocarbon solvent, still more preferably a chain hydrocarbon solvent containing 5 to 8 carbon atoms, and even more preferably at least one selected from the group consisting of pentane, hexane, heptane and octane.

The boiling point of the hydrophobic solvent is not particularly limited. From the viewpoint of ease of removal in the solvent removal step described later, the boiling point of the hydrophobic solvent is preferably 130°C or less, and more preferably 100°C or less. On the other hand, the boiling point of the hydrophobic solvent is preferably 50°C or more, and more preferably 60°C or more, from the point of view that the hydrophobic solvent can be easily included in the precursor particles.

When the hydrophobic solvent is a mixed solvent containing more than one kind of hydrophobic solvent and it has more than one boiling point, the boiling point of the solvent having the highest boiling point among the solvents contained in the mixed solvent, is preferably equal to or less than the upper limit value, and the boiling point of the solvent having the lowest boiling point among the solvents contained in the mixed solvent, is preferably equal to or more than the lower limit value.

The relative permittivity of the hydrophobic solvent at 20°C is preferably 2.5 or less. The relative permittivity is one of the indices of the level of the polarity of a compound. In the case where the hydrophobic solvent has a sufficiently small relative permittivity of 2.5 or less, it is considered that phase separation progresses rapidly in the droplets of the monomer composition and the hollow portion can be easily formed.

Examples of hydrophobic solvents having a relative permittivity at 20°C of 2.5 or less, are as follows. The inside of the parentheses is the value of relative permittivity.

Pentane (1.8), hexane (1.9), heptane (1.9), octane (1.9), cyclohexane (2.0)

For the relative permittivity at 20°C, values written in known literatures (for example, the Chemical Society of Japan, as editor, "Kagaku Binran, Kiso Hen, Kaitei 4 Ban", pp. II-498 to II-503, published by Maruzen Publishing Co., Ltd. on September 30, 1993) and other technical information may be used as reference. Examples of the method of measuring the relative permittivity at 20°C include a relative permittivity test that is in conformity with 23 of JIS C 2101:1999 and is performed with the measuring temperature set to 20°C.

The void ratio of the hollow particles can be controlled by changing the amount of the hydrophobic solvent in the mixture liquid. In the suspension step described later, the polymerization reaction progresses while oil droplets containing the polymerizable monomer and so on include the hydrophobic solvent. Accordingly, as the content of the hydrophobic solvent increases, the void ratio of the obtained hollow particles tends to increase.

In the present disclosure, with respect to 100 parts by mass of the polymerizable monomer, the content of the hydrophobic solvent in the mixture liquid is preferably 100 parts by mass or more and 650 parts by mass or less, from the following viewpoints: the particle diameter of the hollow particles can be easily controlled; the void ratio can be easily increased while maintaining the strength of the hollow particles; and the amount of the residual hydrophobic solvent in the hollow particles can be easily decreased. The content of the hydrophobic solvent in the mixture liquid is more preferably 120 parts by mass or more and 500 parts by mass or less, and still more preferably 140 parts by mass or more and 300 parts by mass or less, with respect to 100 parts by mass of the polymerizable monomer.

(C) Polymerization initiator

In the production method of the present disclosure, the mixture liquid preferably contains an oil-soluble polymerization initiator as the polymerization initiator. The oil-soluble polymerization initiator is not particularly limited, as long as it is a lipophilic one having a solubility in water of 0.2% by mass or less. As the oil-soluble polymerization initiator, examples include, but are not limited to, an organic peroxide such as benzoyl peroxide, lauroyl peroxide, t-butyl peroxy-2-ethylhexanoate, t-butylperoxy diethylacetate and t-butylperoxy pivalate, and an azo compound such as 2,2'-azobis(2,4-dimethylvaleronitrile), azobis(isobutyronitrile) and 2,2'-azobis(4-methoxy-2,4-dimethylvaleronitrile). Of them, an organic peroxide is preferably used as the oil-soluble polymerization initiator, from the point of view that the dielectric property of the hollow particles is easily improved. In the case of using an organic peroxide as the polymerization initiator, the amount of the unreacted polymerizable monomer remaining in the shell is easily decreased. When a decomposition product of the polymerization initiator remains in the shell, the molecular motion of the shell tends to increase; however, a decomposition product of the organic peroxide is easily removed. Accordingly, in the case of using an organic peroxide as the polymerization initiator, the amount of the decomposition product of the polymerization initiator and unreacted polymerizable monomer remaining in the shell can be decreased, and an increase in the molecular motion of the shell can be suppressed, accordingly.

With respect to 100 parts by mass of the polymerizable monomer in the mixture liquid, the content of the polymerization initiator is preferably from 0.1 parts by mass to 10 parts by mass, more preferably from 0.5 parts by mass to 7 parts by mass, and still more preferably from 1 part by mass to 5 parts by mass. When the content of the polymerization initiator is equal to or more than the lower limit value, a polymerization reaction can progress sufficiently. When the content of the polymerization initiator is equal to or less than the upper limit value, the polymerization initiator is less likely to remain after the end of the polymerization reaction, and an unexpected side reaction is less likely to progress.

(D) Dispersion stabilizer

The dispersion stabilizer is an agent for dispersing the droplets of the monomer composition in the aqueous medium in the suspension step. As the dispersion stabilizer, examples include, but are not limited to, an inorganic dispersion stabilizer, an organic or inorganic water-soluble polymer stabilizer and a surfactant.

In the present disclosure, an inorganic dispersion stabilizer is preferably used as the dispersion stabilizer, from the following viewpoints: the particle diameter of the droplets can be easily controlled in the suspension, and the dispersion stabilizer can be easily removed by the washing step; moreover, an excessive decrease in the shell thickness is suppressed, and a decrease in the strength of the hollow particles is suppressed.

As the inorganic dispersion stabilizer, examples include, but are not limited to, inorganic compounds including a sulfate such as barium sulfate and calcium sulfate; a carbonate such as barium carbonate, calcium carbonate and magnesium carbonate; a phosphate such as calcium phosphate; a metal oxide such as aluminum oxide and titanium oxide; a metal hydroxide such as aluminum hydroxide, magnesium hydroxide, calcium hydroxide, barium hydroxide and iron(II)hydroxide; and silicon dioxide. These inorganic dispersion stabilizers may be used alone or in combination of two or more.

As the inorganic dispersion stabilizer, a sparingly water-soluble inorganic dispersion stabilizer is preferably used. The term "sparingly water-soluble" is preferably such that the solubility in water at 25°C is less than 1 g/L.

As the sparingly water-soluble inorganic dispersion stabilizer, a metal hydroxide is preferred, and a magnesium hydroxide is more preferred.

In the present disclosure, the sparingly water-soluble inorganic dispersion stabilizer is particularly preferably used in the form of colloidal particles being dispersed in the aqueous medium, that is, in the form of a colloidal dispersion containing the sparingly water-soluble, inorganic dispersion stabilizer colloidal particles. Accordingly, the inorganic dispersion stabilizer can be easily removed by the washing step described below.

The colloidal dispersion containing the sparingly water-soluble inorganic dispersion stabilizer colloidal particles can be prepared by, for example, reacting at least one selected from the group consisting of alkali metal hydroxide salts and alkaline earth metal hydroxide salts with a water-soluble polyvalent metal salt, which is not an alkaline earth metal hydroxide salt, in the aqueous medium.

As the alkali metal hydroxide salts, examples include, but are not limited to, lithium hydroxide, sodium hydroxide and potassium hydroxide. As the alkaline earth metal hydroxide salts, examples include, but are not limited to, barium hydroxide and calcium hydroxide.

The water-soluble polyvalent metal salt is only required to be a water-soluble polyvalent metal salt other than compounds corresponding to the above-mentioned alkaline earth metal hydroxide salts. As the polyvalent metal salt, examples include, but are not limited to, magnesium metal salts such as magnesium chloride, magnesium phosphate and magnesium sulfate; calcium metal salts such as calcium chloride, calcium nitrate, calcium acetate and calcium sulfate; aluminum metal salts such as aluminum chloride and aluminum sulfate; barium salts such as barium chloride, barium nitrate and barium acetate; and zinc salts such as zinc chloride, zinc nitrate and zinc acetate. Among them, magnesium metal salts, calcium metal salts and aluminum metal salts are preferred; magnesium metal salts are more preferred; and magnesium chloride is particularly preferred.

The method for reacting the water-soluble polyvalent metal salt with the at least one selected from the group consisting of alkali metal hydroxide salts and alkaline earth metal hydroxide salts in the aqueous medium, is not particularly limited. For example, an aqueous solution of the water-soluble polyvalent metal salt may be mixed with an aqueous solution of the at least one selected from the group consisting of alkali metal hydroxide salts and alkaline earth metal hydroxide salts.

Also, colloidal silica may be used as the colloidal dispersion containing the sparingly water-soluble inorganic dispersion stabilizer colloidal particles.

As the organic water-soluble polymer stabilizer, examples include, but are not limited to, polyvinyl alcohol, a polycarboxylic acid (such as polyacrylic acid), a cellulose (such as hydroxyethyl cellulose, carboxymethyl cellulose, methyl cellulose and ethyl cellulose), polyvinylpyrrolidone, polyacrylimide, polyethylene oxide and a poly(hydroxystearic acid-g-methyl methacrylate-co-methacrylic acid) copolymer.

As the inorganic water-soluble polymer stabilizer, examples include, but are not limited to, sodium tripolyphosphate.

The surfactant is a compound containing both a hydrophilic group and a hydrophobic group per molecule. As the surfactant, examples include, but are not limited to, a conventionally-known ionic surfactant such as an anionic surfactant, a cationic surfactant and an amphoteric surfactant, and a conventionally-known non-ionic surfactant.

For the water-soluble polymer stabilizer and the surfactant, the solubility in water at 25°C is 1 g/L or more.

The content of the dispersion stabilizer is not particularly limited. With respect to the total mass (100 parts by mass) of the polymerizable monomer and the hydrophobic solvent, the content of the dispersion stabilizer is preferably from 0.5 parts by mass to 15 parts by mass, and more preferably from 1 part by mass to 10 parts by mass. When the content of the dispersion stabilizer is equal to or more than the lower limit value, the droplets of the monomer composition can be sufficiently dispersed in the suspension so that they do not join together. On the other hand, when the content of the dispersion stabilizer is equal to or less than the upper limit value, an increase in the viscosity of the suspension is prevented in the formation of the droplets, and a problem such that a droplet forming machine is clogged with the suspension, can be avoided.

With respect to 100 parts by mass of the aqueous medium, the content of the dispersion stabilizer is preferably from 0.5 parts by mass to 15 parts by mass, and more preferably from 0.5 parts by mass to 10 parts by mass.

In the hollow particles of the present disclosure, from the viewpoint of suppressing a deterioration of the dielectric property and a deterioration of the reliability, the amount of the residual dispersion stabilizer is preferably as small as possible. The hollow particles are most preferably free of the dispersion stabilizer. The hollow particles containing neither the water-soluble polymer stabilizer nor the surfactant are particularly preferred. By using only the inorganic dispersion stabilizer as the dispersion stabilizer, the hollow particles in which both the water-soluble polymer stabilizer and the surfactant are below the detection limit, can be obtained.

(E) Aqueous medium

In the present disclosure, the term "aqueous medium" means a medium selected from the group consisting of water, a hydrophilic solvent and a mixture thereof.

When a mixture of water and a hydrophilic solvent is used, from the viewpoint of forming the droplets of the monomer composition, it is important that the polarity of the entire mixture is not too low. In this case, for example, the mass ratio between water and the hydrophilic solvent (water : hydrophilic solvent) may be set to 99:1 to 50:50.

In the present disclosure, the hydrophilic solvent is not particularly limited, as long as it is one that mixes with water sufficiently and does not develop phase separation. As the hydrophilic solvent, examples include, but are not limited to, alcohols such as methanol and ethanol, tetrahydrofuran (THF), and dimethyl sulfoxide (DMSO).

The content of the aqueous medium is not particularly limited. From the viewpoint of controlling the particle diameter and void ratio of the hollow particles in the preferred ranges described below, with respect to 100 parts by mass of the polymerizable monomer contained in the mixture liquid, the content of the aqueous medium is, as the lower limit thereof, preferably 200 parts by mass or more, more preferably 400 parts by mass or more, and still more preferably 600 parts by mass or more. The content is, as the upper limit thereof, preferably 1000 parts by mass or less, and more preferably 800 parts by mass or less.

The mixture liquid may further contain other materials that are different from the above-mentioned materials (A) to (E), to the extent that does not impair the effects of the present disclosure.

The mixture liquid is obtained by mixing the above-mentioned materials and other materials as needed, appropriately stirring the mixture, etc. In the mixture liquid, an oil phase containing lipophilic materials such as (A) the polymerizable monomer, (B) hydrophobic solvent and (C) the polymerization initiator is dispersed with a size of a particle diameter of approximately several millimeters in an aqueous phase containing (D) the dispersion stabilizer, (E) the aqueous medium, etc. The dispersion state of these materials in the mixture liquid can be observed with the naked eye, depending on the types of the materials.

In the mixture liquid preparation step, the mixture liquid may be obtained by simply mixing the above-mentioned materials and other materials as needed, appropriately stirring the mixture, etc. From the point of view that the shell can be easily uniform, it is preferable to prepare the mixture liquid by separately preparing the oil phase, which contains the polymerizable monomer, the hydrophobic solvent and the polymerization initiator, and the aqueous phase, which contains the dispersion stabilizer and the aqueous medium, in advance, and then mixing the phases together. In the present disclosure, a colloidal dispersion in which a sparingly water-soluble inorganic dispersion stabilizer is dispersed in the form of colloidal particles in the aqueous medium, can be preferably used as the aqueous phase.

As just described, by separately preparing the oil phase and the aqueous phase in advance and then mixing them, hollow particles in which the composition of the shell portion is uniform, can be produced. Also, the particle diameter of the hollow particles can be easily controlled.

(2) Suspension step

The suspension step includes suspending the mixture liquid to prepare the suspension in which the droplets of the monomer composition containing the hydrophobic solvent are dispersed in the aqueous medium.

The suspension method for forming the droplets of the monomer composition is not particularly limited, and a known suspension method can be employed. A disperser is used to prepare the suspension. As the disperser, for example, a horizontal or vertical in-line disperser such as MILDER (manufactured by Pacific Machinery & Engineering Co., Ltd.), CAVITRON (manufactured by EUROTEC, Ltd.) and an in-line disperser manufactured by IKA (e.g., DISPAX-REACTOR (registered trademark) DRS) or an emulsifying disperser such as HOMOMIXER MARK II series (manufactured by PRIMIX Corporation) can be used.

In the dispersion for the preparation of the suspension, from the viewpoint of controlling the particle diameter of the hollow particles within the above-described preferred range, the tip speed of the rotor of the disperser is preferably 5 m/s or more, more preferably 10 m/s or more, and still more preferably 15 m/s or more. On the other hand, from the viewpoint of decreasing the amount of the irregular-shaped particles, it is preferably 90 m/s or less, more preferably 89 m/s or less, and still more preferably 88 m/s or less.

In the suspension prepared in the suspension step, the droplets of the monomer composition containing the lipophilic materials mentioned above and having a particle diameter of approximately from 0.1 $\mu$m to 10 $\mu$m, are dispersed uniformly in the aqueous medium. Such droplets of the monomer composition are difficult to observe with the naked eye and can be observed with a known observation instrument such as an optical microscope.

In the suspension step, since phase separation occurs in the droplets of the monomer composition, the hydrophobic solvent with low polarity is likely to collect in the interior of the droplets. As a result, in the obtained droplets, the hydrophobic solvent is distributed in the interior thereof, and the material not containing the hydrophobic solvent is distributed at the periphery thereof.

The droplets of the monomer composition dispersed in the aqueous medium are formed of the oil-soluble monomer composition and the dispersion stabilizer surrounding the periphery of the oil-soluble monomer composition. The droplets of the monomer composition contain the oil-soluble polymerization initiator, the polymerizable monomer and the hydrophobic solvent.

The droplets of the monomer composition are minute oil droplets, and the oil-soluble polymerization initiator generates polymerization initiating radicals in the interior of the minute oil droplets. Therefore, the precursor particles having a target particle diameter can be produced without an excessive growth of the minute oil droplets.

In the suspension polymerization method using such an oil-soluble polymerization initiator, there is no opportunity for the polymerization initiator to come into contact with the polymerizable monomer dispersed in the aqueous medium. Therefore, by using the oil-soluble polymerization initiator, the subgeneration of surplus resin particles (e.g., solid particles having a relatively small particle diameter) in addition to the target resin particles having the hollow portion, can be suppressed.

(3) Polymerization step

The polymerization step includes subjecting the suspension to a polymerization reaction to prepare the precursor composition in which the precursor particles comprising the shell, which contains the resin, and the hollow portion, which is surrounded by the shell and filled with the hydrophobic solvent, are dispersed in the aqueous medium.

In this step, the shell portion of the droplets of the monomer composition, which contain the hydrophobic solvent in the interior thereof, is polymerized, the hollow portion filled with the hydrophobic solvent is formed in the interior of the precursor particles thus obtained.

In this step, during the polymerization reaction, the crosslinkable monomer may be added to the suspension to further continue the polymerization reaction. The crosslinkable monomer having a solubility in water at 20°C of from 0.5 g/L to 1000 g/L, is particularly preferably added during the polymerization reaction, rather than during the mixture liquid preparation step. Accordingly, more reactive unsaturated bonds can be introduced onto the outer surface of the shell, and the unsaturated bond amount of the hollow particles can be increased. In addition, the solvent resistance of the hollow particles can be improved by adding the crosslinkable monomer having the above solubility to the suspension during the polymerization reaction to further continue the polymerization reaction.

The solubility in water at 20°C of the crosslinkable monomer added during the polymerization reaction, is preferably lager than the hydrophobic solvent and from 0.5 g/L to 1000 g/L, and more preferably from 0.5 g/L to 80 g/L. By adding, during the polymerization reaction, the crosslinkable monomer which the solubility in water at 20°C is within the above ranges, the crosslinkable monomer is easily incorporated onto the shell surface, and the reactive unsaturated bond can be efficiently introduced onto the shell surface. The solubility in water at 20°C of the crosslinkable monomer added during the polymerization reaction, is still more preferably 50 g/L or less, even more preferably 20 g/L or less, and particularly preferably 10 g/L or less as the upper limit. On the other hand, it is still more preferably 1.0 g/L or more, and even more preferably 2.0 g/L or more as the lower limit.

The molecular weight of the crosslinkable monomer added during the polymerization reaction, is preferably 300 or less, and more preferably 200 or less since the crosslinkable monomer is easily incorporated onto the shell surface. The lower limit of the molecular weight is not particularly limited, and it is generally 50 or more.

As the crosslinkable monomer added during the polymerization reaction, for example, a crosslinkable acrylic monomer is preferably used, such as allyl (meth)acrylate, ethylene glycol di(meth)acrylate, diethylene glycol di(meth) acrylate, triethylene glycol di(meth)acrylate and 1,3-bis(methacryloyloxy)-2-hydroxypropane.

In the case of adding the crosslinkable monomer to the suspension during the polymerization reaction, from the viewpoint of efficiently introducing the reactive unsaturated bond onto the shell surface, the timing of the addition is preferably when the polymerization conversion rate of the polymerizable monomer in the suspension is 80% by mass or less, more preferably 60% by mass or less, and still more preferably 40% by mass or less as the upper limit. On the other hand, the timing is preferably when the polymerization conversion rate is 10% by mass or more as the lower limit.

The polymerization conversion rate at the time of adding the crosslinkable monomer to the suspension during the polymerization reaction, is obtained by the following formula (VI) using the mass of the polymerizable monomer contained in the suspension before the addition and the mass of the unreacted polymerizable monomer contained in the suspension just before the addition. The mass of the polymerizable monomer contained in the suspension before the addition is the total mass of the polymerizable monomer after the polymerization reaction and the unreacted polymerizable monomer.

Polymerization conversion rate (% by mass) = 100 - (Mass of the unreacted polymerizable monomer/ Mass of the polymerizable monomer contained in the suspension) $\times$ 100          Formula (IV)

When the crosslinkable monomer is added to the suspension during the polymerization reaction, from the viewpoint of efficiently introducing the reactive unsaturated bond onto the shell surface, the amount of the crosslinkable monomer added during the polymerization reaction is preferably 1 part by mass or more, more preferably 2 parts by mass or more, with respect to 100 parts by mass of the polymerizable monomer in the mixture liquid. On the other hand, from the viewpoint of suppressing a deterioration in the dielectric property, it is preferably 10 parts by mass or less, and more preferably 8 parts by mass or less.

In the present disclosure, from the viewpoint of improving the reliability by introducing a sufficient amount of reactive unsaturated bond onto the shell surface, from the viewpoint of improving the shell strength, and from the point of view that the hollow particles can easily keep a high void ratio and obtain excellent dielectric property, the content of the crosslinkable monomer in 100% by mass of the polymerizable monomer added until the polymerization step, is preferably 50% by mass or more, more preferably 60% by mass or more, still more preferably 70% by mass or more, even more preferably 80% by mass or more, and particularly preferably 90% by mass or more. The dielectric dissipation factor of the hollow particles is likely to decrease when the crosslinkable monomer and the non-crosslinkable monomer are contained in combination as the polymerizable monomer. From the viewpoint of decreasing the dielectric dissipation factor of the hollow particles, the content of the crosslinkable monomer in 100% by mass of the polymerizable monomer added until the polymerization step, is preferably 80% by mass or less, and more preferably 70% by mass or less.

From the viewpoint of improving the dielectric property of the hollow particles, the content of the hydrocarbon monomer in 100% by mass of the polymerizable monomer added until the polymerization step is preferably 70% by mass or more, more preferably 80% by mass or more, and still more preferably 90% by mass or more. The polymerizable monomer may consist of the hydrocarbon monomer. As the percentage of the hydrocarbon monomer in the polymerizable monomer increases, the dielectric property of the hollow particles tends to improve. Meanwhile, from the viewpoint of efficiently introducing the reactive unsaturated bond onto the shell surface by use of the crosslinkable monomer which contains a heteroatom, the content of the hydrocarbon monomer may be 98% by mass or less, may be 95% by mass or less, or may be 90% by mass or less.

The content of each monomer in 100% by mass of the polymerizable monomer added until the polymerization step, corresponds to the content of each monomer unit in 100% by mass of all the monomer units of the polymer contained in the shell.

In the polymerization step, the polymerization system is not particularly limited. For example, a known polymerization system such as a batch system, a semicontinuous system and a continuous system may be employed.

The polymerization temperature is not particularly limited. From the viewpoint of sufficiently promoting the polymerization reaction, the polymerization temperature is preferably 60°C or more, more preferably 70°C or more, and still more preferably 80°C or more. From the viewpoint of suppressing the evaporation of the aqueous medium, the polymerization temperature is preferably 95°C or less.

The polymerization reaction time is not particularly limited. From the viewpoint of sufficiently promoting the polymerization reaction, the polymerization reaction time is preferably 5 hours or more, and more preferably 10 hours or more. From the viewpoint of production efficiency, the polymerization reaction time is preferably 60 hours or less, more preferably 48 hours or less, and particularly preferably 36 hours or less.

When the crosslinkable monomer is added to the suspension during the polymerization reaction, the polymerization reaction time before the addition of the crosslinkable monomer is preferably from 10 minutes to 3 hours, and more preferably from 30 minutes to 2 hours. The polymerization reaction time after the addition of the crosslinkable monomer is preferably from 1 hour to 48 hours, and more preferably from 2 hours to 24 hours.

During the polymerization reaction, the suspension is generally stirred. The stirring power of the stirring is not particularly limited. From the viewpoint of promoting the polymerization reaction, the stirring power is preferably 0.01 kW/m$^3$ or more, more preferably 0.02 kW/m$^3$ or more, and still more preferably 0.03 kW/m$^3$ or more. From the viewpoint of decreasing the amount of the irregular-shaped particles, it is preferably 0.20 kW/m$^3$ or less, more preferably 0.10 kW/m$^3$ or

less, and still more preferably 0.05 kW/m$^3$ or less.

(4) Solvent removal step

The solvent removal step includes removing the hydrophobic solvent from the precursor particles to obtain the aqueous dispersion of the hollow particles, by bubbling the gas into the precursor composition while stirring the precursor composition in the stirring tank. By this step, the aqueous dispersion of the hollow particles in which the hollow portion is filled with the bubbled gas, is obtained.

The gas can be bubbled into the precursor composition by, for example, directly introducing the gas into the precursor composition, that is, by directly injecting the gas into the precursor composition. Alternatively, the gas in the vapor phase can be bubbled into the precursor composition by stirring the precursor composition in the stirring tank containing a vapor phase and a liquid phase which contains the precursor composition. Especially from the viewpoint of efficient removal of the hydrophobic solvent included in the precursor particles and efficient removal of the unreacted polymerizable monomer and so on remaining in the precursor particles, the gas is preferably bubbled into the precursor composition by, while directly introducing the gas into the precursor composition, stirring the precursor composition in the stirring tank containing the vapor phase. The vapor phase in the stirring tank is preferably filled with the gas in advance, which is bubbled into the precursor composition.

The gas bubbled into the precursor composition is preferably at least one selected from the group consisting of inert gas and air, and it is more preferably inert gas. As the inert gas, examples include, but are not limited to, nitrogen, argon and helium. Of them, nitrogen is preferred.

In this step, from the viewpoint of efficient removal of the hydrophobic solvent included in the precursor particles and efficient removal of the unreacted polymerizable monomer and so on remaining in the precursor particles, the time required to bubble the gas into the precursor composition is preferably two hours or more, more preferably 5 hours or more, still more preferably 10 hours or more, and even more preferably 15 hours or more. On the other hand, from the viewpoint of production efficiency, it is preferably 72 hours or less, and more preferably 60 hours or less.

When the polymerization reaction time of the above-described polymerization step is 50 hours or more, the hydrophobic solvent included in the precursor particles and the unreacted polymerizable monomer and so on contained in the precursor particles can be sufficiently removed even when the bubbling time of the solvent removal step is less than two hours. When the polymerization reaction time of the above-described polymerization step is 50 hours or more, the bubbling time of the solvent removal step is preferably 20 minutes or more, and more preferably 30 minutes or more.

In this step, the stirring power for stirring the precursor composition is not particularly limited. From the viewpoint of efficient removal of the hydrophobic solvent included in the precursor particles and efficient removal of the unreacted polymerizable monomer and so on remaining in the precursor particles, the stirring power is preferably 0.01 kW/m$^3$ or more, more preferably 0.02 kW/m$^3$ or more, and still more preferably 0.03 kW/m$^3$ or more. On the other hand, from the viewpoint of decreasing the amount of the irregular-shaped particles and suppressing the foaming of the precursor composition, the stirring power is preferably 0.60 kW/m$^3$ or less, more preferably 0.55 kW/m$^3$ or less, still more preferably 0.50 kW/m$^3$ or less, even more preferably 0.20 kW/m$^3$ or less, and particularly preferably 0.10 kW/m$^3$ or less, and it may be 0.05 kW/m$^3$ or less.

In this step, from the viewpoint of efficient removal of the hydrophobic solvent included in the precursor particles and efficient removal of the unreacted polymerizable monomer and so on remaining in the precursor particles, the gas is preferably bubbled into the precursor composition under a pressure of 20 kPa or more and 300 kPa or less, and more preferably under a pressure of 40 kPa or more and 200 kPa or less. The pressure is preferably equal to or more than the lower limit value, since the yield of the hollow particles is increased. Also, the pressure is preferably equal to or less than the upper limit value, since the amount of the irregular-shaped particles can be decreased. Especially from the viewpoint of excellent hydrophobic solvent removal efficiency, the gas is preferably bubbled into the precursor composition under a pressure of atmospheric pressure or less, and more preferably under a reduced pressure of 60 kPa or less. On the other hand, from the viewpoint of suppressing the foaming of the precursor composition, the gas is preferably bubbled into the precursor composition under a pressure of 150 kPa or more. The yield of the hollow particles is increased by suppressing the foaming of the precursor composition during the bubbling. The pressure may be the internal pressure of the stirring tank.

The flow rate of the gas introduced into the stirring tank is not particularly limited. From the viewpoint of efficient removal of the hydrophobic solvent included in the precursor particles and efficient removal of the unreacted polymerizable monomer and so on remaining in the precursor particles, the flow rate per unit time is preferably 4 L/min or more, more preferably 8 L/min or more, and still more preferably 10 L/min or more. The flow rate per unit volume is preferably 200 L/(min·m$^3$) or more, more preferably 8,000 L/(min·m$^3$) or more, and still more preferably 10,000 L/(min·m$^3$) or more. From the viewpoint of cost reduction, the upper limit of the gas flow rate per unit time may be 10,000 L/min or less, and the upper limit of the gas flow rate per unit volume may be 500,000 L/(mim·m$^3$) or less.

In the case of using a stirring tank with a capacity of 3 L to 15000 L, the gas flow rate is preferably within the above range.

In this step, the stirring tank preferably contains the vapor phase and the liquid phase which contains the precursor composition. This is because, when the stirring tank preferably contains the vapor phase, the hydrophobic solvent included in the precursor particles and the unreacted polymerizable monomer and so on contained in the precursor particles can pass into the vapor phase, and they can be removed with high efficiency, accordingly.

With respect to the capacity of the stirring tank, the percentage of the liquid phase contained therein is preferably 30% by volume or more and less than 80% by volume, from the viewpoint of efficient removal of the hydrophobic solvent included in the precursor particles and efficient removal of the unreacted polymerizable monomer and so on remaining in the precursor particles.

The method for directly introducing the gas into the precursor composition, is preferably direct introduction of the gas into the precursor composition in the stirring tank from the side or bottom of the stirring tank, and more preferably direct introduction of the gas from the bottom of the stirring tank, for example. The bottom of the stirring tank is a part that can be observed when viewing the stirring tank in use from the bottom. The stirring tank is typically in a columnar form. The bottom face which is located on the lower side of the direction of the force of gravity, is the bottom of the columnar stirring tank, and it is the deepest part thereof.

In the case of directly introducing the gas into the precursor composition, the gas introduction portion is preferably as close as possible to the deepest part of the stirring tank, since the gas can be easily and uniformly bubbled into the precursor composition. Once the gas is uniformly bubbled into the precursor composition, the hydrophobic solvent and the unreacted polymerizable monomer and so on, which are removed from the precursor particles, can easily pass into the upper vapor phase, and they can be removed with high efficiency, accordingly.

Also, the gas is preferably introduced into the precursor composition toward the center of the region occupied by the precursor composition in the stirring tank, since the gas can be easily and uniformly bubbled in to the precursor composition. That is, in the case of introducing the gas from the bottom of the stirring tank, the gas is preferably introduced toward the direction opposite to the direction of the force of gravity.

The direction of the force of gravity in the present disclosure does not always need to be aligned with the direction of the force of gravity. For example, an axis misalignment of 30 degrees or less is allowed.

Meanwhile, the yield of the hollow particles may be increased by bubbling the gas in the vapor phase into the precursor composition just by introducing the gas into the vapor phase in the stirring tank and stirring the precursor composition in the stirring tank, instead of direct introduction of the gas into the precursor composition.

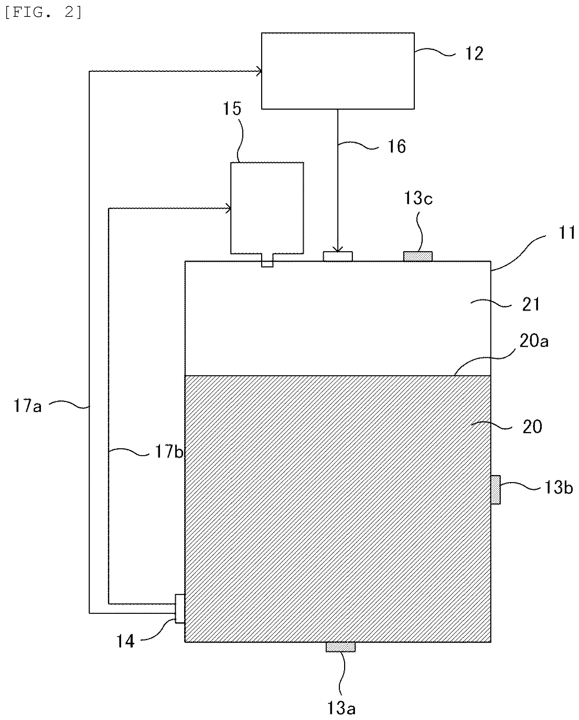

This step can be carried out by the stirring apparatus as shown in FIG. 2, for example. FIG. 2 is merely a schematic diagram for description, and the stirring apparatus used in the solvent removal step of the present disclosure is not limited to the method shown in FIG. 2. Further, the structure, dimension, shape and so on of the stirring apparatus used in the solvent removal step of the present disclosure are not limited to the structure, dimension, shape and so on shown in FIG. 2.

In the stirring apparatus shown in FIG. 2, once the precursor composition (a slurry solution) is supplied to a supply tank 12, the precursor composition is supplied from the supply tank 12 to the interior of a stirring tank 11 through a supply line 16. The method for supplying the precursor composition is not particularly limited, and the precursor composition may be supplied by use of a liquid feed pump, for example. The precursor composition is supplied to the interior of the stirring tank 11 through an inner nozzle (not shown). A precursor composition 20 (the precursor composition) in the stirring tank 11 is stirred by rotating a rotor (not shown) disposed in the interior of the stirring tank 11.

The stirring tank 11 includes gas inlets 13a, 13b and 13c. The gas can be introduced into the stirring tank 11 through the gas inlet 13a, 13b or 13c. The gas inlet 13a is disposed on the bottom of the stirring tank 11. The gas inlet 13b is disposed on the side of the stirring tank 11. When the gas is introduced from the gas inlet 13a or 13b, the gas can be directly injected and bubbled into the precursor composition 20 in the stirring tank 11. The gas inlet 13c is disposed on the top of the stirring tank 11. When the gas is introduced from the gas inlet 13c, the gas is injected into a vapor phase 21 in the interior of the stirring tank 11. By stirring the precursor composition 20 in the stirring tank 11, the gas in the vapor phase 21 is bubbled into the precursor composition 20.

In the stirring apparatus shown in FIG. 2, the precursor composition 20 can be circulated in the stirring apparatus by returning the precursor composition 20 stirred in the stirring tank 11 from an outlet 14 to the interior of the stirring tank 11 through a circulation line 17a, the supply tank 12 and the supply line 16.

The stirring apparatus shown in FIG. 2 further includes a spray mechanism 15. In the stirring apparatus shown in FIG. 2, a part of the precursor composition 20 stirred in the stirring tank 11 can be supplied from the outlet 14 to the spray mechanism 15 through a circulation line 17b and then sprayed to a liquid surface 20a of the precursor composition 20 in the stirring tank 11.

The internal pressure of the stirring tank 11 can be controlled by controlling the flow rate of the precursor composition discharged from the stirring tank 11.

In this step, during the bubbling of the gas into the precursor composition, a cycle of supplying the precursor composition from the supply tank to the stirring tank, stirring the precursor composition in the stirring tank and then discharging the precursor composition to the supply tank, is preferably repeated to circulate the precursor composition in the stirring apparatus. Accordingly, the hydrophobic solvent included in the precursor particles and the unreacted polymerizable monomer and so on contained in the precursor particles can be efficiently removed. The flow rate of the circulation is not particularly limited.

In this step, a part of the precursor composition is preferably supplied from the stirring tank to the spray mechanism and sprayed to the liquid surface of the precursor composition in the stirring tank when bubbling the gas into the precursor composition. Accordingly, the hydrophobic solvent included in the precursor particles and the unreacted polymerizable monomer and so on contained in the precursor particles can be efficiently removed, and the bubbling time can be shortened, therefore.

The precursor composition can be continuously or intermittently sprayed during the bubbling of the gas into the precursor composition. The precursor composition is preferably sprayed continuously. In the case of intermittently spraying the precursor composition, the precursor composition is preferably appropriately sprayed until, upon the foaming of the precursor composition and a rise in the liquid surface, the foam disappears. In the case of spraying the precursor composition, the amount of the sprayed precursor composition is not particularly limited.

The temperature at the time of bubbling the gas into the precursor composition is preferably a temperature equal to or more than the temperature obtained by subtracting 35°C from the boiling point of the hydrophobic solvent, more preferably a temperature equal to or more than the temperature obtained by subtracting 30°C from the boiling point of the hydrophobic solvent, and still more preferably a temperature equal to or more than the temperature obtained by subtracting 20°C from the boiling point of the hydrophobic solvent, from the viewpoint of decreasing the amount of the residual hydrophobic solvent. When the hydrophobic solvent is a mixed solvent containing more than one type of hydrophobic solvent and it has more than one boiling point, the boiling point of the hydrophobic solvent in the solvent removal step is determined as the boiling point of the solvent having the highest boiling point among the solvents contained in the mixed solvent, that is, the highest boiling point of the more than one boiling point.

The temperature at the time of bubbling the gas into the precursor composition is generally set to a temperature equal to or more than the polymerization temperature of the polymerization step.

The temperature at the time of bubbling the gas into the precursor composition is not particularly limited, and it may be from 50°C to 100°C.

(5) Washing step

The above-described production method includes the washing step after the solvent removal step described above. The washing step is for removal of the dispersion stabilizer remaining in the hollow particles obtained by the above-described solvent removal step.

For example, the washing step is preferably carried out by repeating a series of the following steps two or more times: adding acid or alkali to the aqueous dispersion of the hollow particles obtained by the solvent removal step to dissolve the dispersion stabilizer contained in the hollow particles into the aqueous medium, separating the hollow particles from the aqueous medium, dispersing the separated hollow particles in deionized water to be reslurried, and then separating the hollow particles. From the point of view that the residual dispersion stabilizer is further removed from the hollow particles and the dielectric dissipation factor of the hollow particles is likely to decrease, a series of the operations of dispersing the acid- or alkali-added, separated hollow particles in deionized water to be reslurried and then separating the hollow particles, is preferably repeated three times or more in the washing step. The number of times to carry out the series of the operations is preferably 4 times or more, and more preferably 5 times or more. The upper limit of the number of times to carry out the series of the operations is not particularly limited. From the viewpoint of ease of production, it may be 10 times or less, or it may be 8 times or less.

When the dispersion stabilizer used is an acid-soluble inorganic dispersion stabilizer, acid is preferably added. When the dispersion stabilizer used is an alkali-soluble inorganic dispersion stabilizer, alkali is preferably added.

When the dispersion stabilizer used is the acid-soluble inorganic dispersion stabilizer, the pH of the precursor composition is preferably adjusted to 6.5 or less, and more preferably 6 or less, by adding acid to the aqueous dispersion of the hollow particles. As the added acid, an inorganic acid such as sulfuric acid, hydrochloric acid and nitric acid or an organic acid such as formic acid and acetic acid may be used. Of them, sulfuric acid is particularly preferred, due to its high dispersion stabilizer removal efficiency and small burden on production equipment.

The method for separating the hollow particles from the aqueous medium is not particularly limited. As the method, examples include, but are not limited to, a centrifugation method, a filtration method, and still-standing separation. Among them, a filtration method is preferred from the viewpoint of simplicity of the operation and high dispersion stabilizer removal efficiency. Upon the separation of the hollow particles from the aqueous medium, the hollow particles obtained by the filtration method or the like are preferably dehydrated by a known method.

As the filtration method, for example, any method such as natural filtration (normal pressure filtration), reduced pressure filtration, pressure filtration and centrifugal filtration can be used. Of them, pressure filtration is preferred from the viewpoint of efficient removal of the dispersion stabilizer remaining in the hollow particles.

In the production method of the present disclosure, an operation to separate the hollow particles from the aqueous medium is performed several times in the washing step. Pressure filtration is preferably carried out in at least one of the performed operations, and it is more preferably carried out in all of the performed operations.

(6) Drying step

The drying step includes drying the washed hollow particles for removal of residual water.
The hollow particles obtained by the washing step is generally in a cake form. In this step, a dehydrated cake of the hollow particles is generally dried.
In this step, the water content of the hollow particles before drying is generally from 40% to 80%. In the present disclosure, the water content can be calculated by the following formula (VII).

$$\text{Water content (\%)} = \{(w1 - w2) / w1\} \times 100 \quad \text{Formula (VII)}$$

In the formula (VII), w1 represents the mass of a measurement sample, and w2 represents the mass of the measurement sample after the sample is dried at 200°C for 12 hours and then cooled down to 25°C.
The method for drying the washed hollow particles for removal of residual water is not particularly limited, and a known method can be employed. As the method, examples include, but are not limited to, a reduced-pressure drying method, a heat drying method, a flash drying method and a combination thereof.
In the case of employing a heat drying method, the temperature of the heat drying needs to be equal to or less than the maximum temperature at which the shell structure does not collapse. Accordingly, the heating temperature may be from 50°C to 200°C, may be from 70°C to 200°C, or may be from 100°C to 200°C, depending on the composition of the shell.
In the drying step, the hollow particles may be preliminary dried. The preliminary drying may be performed after the washing step by drying the washed hollow particles by use of a drying apparatus such as a dryer and a drying appliance such as a hand dryer.
The drying atmosphere is not particularly limited and may be appropriately selected depending on the intended application of the hollow particles. The examples of the drying atmosphere include, but are not limited to, air, oxygen, nitrogen and argon. Further, by filling the interior of the hollow particles with gas once and then performing reduced pressure drying, hollow particles in which the interior is evacuated are also temporarily obtained.

(7) Others

In addition to the steps (1) to (6) mentioned above, a particle interior substitution step may be added, for example. The particle interior substitution step includes substituting the gas or liquid in the interior of the hollow particles with another gas or liquid. By such substitution, the environment of the interior of the hollow particles can be changed; molecules can be selectively confined in the interior of the hollow particles; or the chemical structure of the interior of the hollow particles can be modified in accordance with the intended application.

[Matrix resin]

As the matrix resin, the resin composition of the present disclosure contains a matrix resin containing a functional group which can react with the reactive unsaturated bond on the hollow particle surface to form a covalent bond. The reaction between the reactive unsaturated bond of the hollow particles and the functional group of the matrix resin is only required to be a covalent bond-forming reaction. For example, it may be an addition reaction or the like.
The functional group of the matrix resin is not particularly limited. From the viewpoint of reactivity, the functional group is preferably at least one selected from the group consisting of a (meth)acryloyl group, a vinyl group, an allyl group, a thiol group and a maleimide group, and more preferably at least one selected from the group consisting of a (meth)acryloyl group and a vinyl group.
From the viewpoint of improving the reliability, the iodine value of the matrix resin containing an ethylenically unsaturated bond such as a (meth)acryloyl group, a vinyl group, an allyl group and a maleimide group, is preferably 1 g/100 g or more, and more preferably 10 g/100 g or more. The upper limit of the iodine value of the matrix resin containing the ethylenically unsaturated bond is not particularly limited. For example, it may be 1000 g/100 g or less.
From the viewpoint of improving the reliability, the thiol value of the matrix resin containing a thiol group (such as thiol resin) is preferably 0.5% or more, and more preferably 1% or more. The upper limit of the thiol value of the thiol resin is not particularly limited. For example, it may be 100% or less. The thiol value can be obtained by the following formula.

Thiol value (%) = {(Molecular weight of the thiol group × Number of thiol groups per molecule)/Molecular weight of the thiol compound} × 100

As the matrix resin containing the functional group, for example, at least one selected from the group consisting of a bis-maleimide resin, a hydrocarbon resin, an unsaturated polyester resin, a modified polyphenylene ether resin, an allyl resin, a thiol resin and raw material compounds of these resins, is preferably used. From the viewpoint of excellent dielectric property and reliability, a modified polyphenylene ether resin is particularly preferably used.

As the modified polyphenylene ether resin, for example, a terminal-modified, known polyphenylene ether resin containing a polyphenylene ether skeleton may be used. From the viewpoint of excellent reactivity with the hollow particles, a modified polyphenylene ether resin terminal-modified by a substituent containing an ethylenically unsaturated bond is preferably used, such as a styrene-modified polyphenylene ether resin and a (meth)acryl-modified polyphenylene ether resin.

The polyphenylene ether resin is not particularly limited. As the polyphenylene ether resin, examples include, but are not limited to, poly(2,6-dimethyl-1,4-phenylene)ether, an alloyed polymer of poly(2,6-dimethyl-1,4-phenylene) ether and polystyrene, and an alloyed polymer of poly(2,6-dimethyl-1,4-phenylene)ether and a styrene-butadiene copolymer.

From the viewpoint of excellent reactivity with the hollow particles, the number average particle diameter of the modified polyphenylene ether resin is preferably 500 or more and 5000 or less, and more preferably 1000 or more and 3000 or less.

As the bis-maleimide resin, examples include, but are not limited to, 4,4'-diphenylmethanebismaleimide, **m-**phenylenebismaleimide, bisphenol A diphenyl ether bismaleimide, 3,3'-dimethyl-5,5'-diethyl-4,4'-diphenylmethanebismaleimide, **4-**methyl-1,3-phenylenebismaleimide and 1,6'-bismaleimide-(2,2,4-trimethyl)hexane.

As the resin containing a maleimide group, a polymer containing a maleimide group may be used, such as "MIR-3000-70MT" and "MIR-5000-60T" (product names, manufactured by Nippon Kayaku Co., Ltd.)

As the hydrocarbon resin, examples include, but are not limited to, a polyfunctional styrene compound, a polymer thereof, and a cyclic olefin polymer. The polymer of the polyfunctional styrene compound may be a homopolymer or copolymer of a polyfunctional styrene compound, or it may be a copolymer of a polyfunctional styrene compound and another monomer. The cyclic olefin polymer may be a homopolymer or copolymer of a cyclic olefin, or it may be a copolymer of a cyclic olefin and another monomer.

As the polyfunctional styrene, examples include, but are not limited to, divinylbenzene, divinylnaphthalene, divinylbiphenyl, 1,2-bis(p-vinylphenyl)ethane, 1,2-bis(m-vinylphenyl)ethane, 1-(p-vinylphenyl)-2-(m-vinylphenyl)ethane, bis(p-vinylphenyl)methane, bis(m-vinylphenyl)methane, p-vinylphenyl-m-vinylphenylmethane, 1,4-bis(p-vinylphenyl) benzene, 1,4-bis(m-vinylphenyl)benzene, 1-(p-vinylphenyl)-4-(m-vinylphenyl)benzene, 1,3-bis(p-vinylphenyl)benzene, 1,3-bis(m-vinylphenyl)benzene, 1-(p-vinylphenyl)-3-(m-vinylphenyl)benzene, 1,6-bis(p-vinylphenyl)hexane, 1,6-bis(m-vinylphenyl)hexane, 1-(p-vinylphenyl)-6-(m-vinylphenyl)hexane and a divinylbenzene polymer (oligomer) having a vinyl group at a side chain thereof.

As the cyclic olefin, examples include, but are not limited to, norbornene, methanooctahydronaphthalene, dimethanooctahydronaphthalene, dimethanododecahydroanthracene, dimethanodecahydroanthracene, trimethanododecahydroanthracene, dicyclopentadiene, 2,3-dihydrocyclopentadiene, methanooctahydrobenzoindene, dimethanooctahydrobenzoindene, methanodecahydrobenzoindene, dimethanodecahydrobenzoindene, methanooctahydrofluorene, dimethanooctahydrofluorene and analogue compounds thereof.

The hydrocarbon resin containing a tertiary carbon reacts with the reactive unsaturated bond of the hollow particles even when the tertiary carbon is withdrawn by the crosslinking agent described below to produce a radical.

As the unsaturated polyester resin, for example, an esterified product of a polyhydric alcohol component and a dibasic acid component containing an unsaturated dibasic acid and, as needed, a saturated dibasic acid, may be used. As long as the effects of the present disclosure are not impaired, the unsaturated polyester resin may be modified by a dicyclopentadiene-based compound or the like.

As the unsaturated dibasic acid, examples include, but are not limited to, maleic acid, maleic anhydride, fumaric acid, itaconic acid and itaconic anhydride.

As the saturated dibasic acid, examples include, but are not limited to, an aliphatic dibasic acid such as adipic acid, an aromatic dibasic acid such as phthalic acid and phthalic anhydride, and a halogenated saturated dibasic acid.

As the polyhydric alcohol, examples include, but are not limited to, a divalent alcohol such as ethylene glycol, propylene glycol, diethylene glycol, triethylene glycol, cyclohexane glycol and p-xylene glycol; a divalent alcohol such as an adduct of a divalent phenol (e.g., hydrogenated bisphenol A, cyclohexanedimethanol, bisphenol A, bisphenol F, bisphenol S, tetrabromo bisphenol A) and an alkylene oxide as typified by a propylene oxide or an ethylene oxide; and a trivalent or higher alcohol such as 1,2,3,4-tetrahydroxybutane, glycerol, trimethylolpropane and pentaerythritol.

The allyl resin may be a polymer or oligomer obtained by use of a compound containing two or more allyl groups per molecule. As the allyl resin, examples include, but are not limited to, diallyl phthalate resin, allyl phenol resin and allyl ester resin.

As the allyl resin, a compound containing two or more allyl groups per molecule may be also used, such as triallyl isocyanurate.

As the thiol resin, for example, polyphenylene sulfide resin is preferably used. The polyphenylene sulfide resin is not particularly limited, and a known resin containing a polyphenylene sulfide skeleton may be used. The polyphenylene sulfide resin also encompasses polymers homologous to polyphenylene sulfide, such as polyphenylene sulfide ketone (PPSK), polyphenylene sulfide sulfone (PPSS) and polybiphenylene sulfide (PBPS).

As the thiol resin, a thiol compound may be also used, such as trimethylolpropane tris(3-mercaptopropionate), 3-mercaptopropionate ester of pentaerythritol, dipentaerythritol hexakis(3-mercaptopropionate), tris-[(3-mercaptopropionyloxy)-ethyl]-isocyanurate, polyethylene glycol=bis(3-mercaptopropionate) and pentaerythritol tetrapropanethiol.

As the matrix resin, the resin composition of the present disclosure may further contain a matrix resin free of the above functional group. As the matrix resin free of the functional group, for example, cyanate resin, silicone resin, polyphenylene ether resin, epoxy resin, benzoxazine resin, polyimide resin, polyester resin, a liquid crystal polymer (LCP) or modified polyolefin resin is preferably used.

In the resin composition of the present disclosure, the content of the matrix resin is not particularly limited. In 100% by mass of the total solid content of the resin composition, the content of the matrix resin is preferably 50% by mass or more, more preferably 70% by mass or more, and still more preferably 80% by mass or more as the lower limit. It is preferably 95% by mass or less, and more preferably 90% by mass or less as the upper limit. When the content of the matrix resin is equal to or more than the lower limit value, a deteriorate in the properties of the resin composition can be suppressed; the formability of the resin composition can be improved; and the mechanical strength of the resin composition can be improved. On the other hand, when the content of the matrix resin is equal to or less than the upper limit value, the hollow particles can be sufficiently contained; therefore, excellent effects are exerted by the hollow particles, such as the effect of decreasing the dielectric dissipation factor, permittivity and weight of the resin composition and the effect of heat insulation.

From the viewpoint of improving the adhesion between the matrix resin and the hollow particles, in 100% by mass of the matrix resin, the content of the matrix resin containing the functional group is preferably 50% by mass or more, more preferably 70% by mass or more, and still more preferably 90% by mass or more.

The matrix resins described above may be used alone or in combination of two or more.

[Crosslinking agent]

The resin composition of the present disclosure preferably contains a crosslinking agent for initiating or promoting the matrix resin curing reaction or the reaction between the reactive unsaturated bond of the hollow particles and the functional group of the matrix resin. The crosslinking agent is appropriately selected depending on the type of the functional group, and it is not particularly limited.

When the matrix resin contains a radically polymerizable group as the functional group, a radical polymerization initiator is preferably contained as the crosslinking agent. As the radical polymerization initiator, examples include, but are not limited to, an organic peroxide such as benzoyl peroxide, di-t-butyl peroxide, dicumyl peroxide, 3,3,5-trimethylhexanoyl peroxide, di-2-ethylhexyl peroxydicarbonate, methyl ethyl ketone peroxide, t-butylperoxy phthalate, t-butylperoxy benzoate, dit-butylperoxy acetate, t-butylperoxy isobutyrate, t-butylperoxy-2-hexanoate, t-butylperoxy-2-ethylhexanoate, t-butylperoxy-3,5,5-trimethylhexanoate, acetyl peroxide, isobutyryl peroxide, octanoyl peroxide, t-butyl peroxide and dit-amyl peroxide; an inorganic peroxide such as ammonium persulfate, potassium persulfate and sodium persulfate; and an azo compound such as 2,2'-azobisisobutyronitrile, 2,2'-azobis-2-methylbutyronitrile and 4,4'-azobis-4-cyanovaleric acid.

The content of the crosslinking agent is appropriately adjusted depending on the type of the crosslinking agent and the matrix resin, and it is not particularly limited.

[Others]

The resin composition of the present disclosure may further contain a solvent. A known solvent can be used as the solvent, and it is appropriately selected depending on the type of the matrix resin.

As needed, the resin composition of the present disclosure may further contain additives such as a curing accelerator, a filler, a coupling agent, a stress reducing agent, a defoaming agent, a leveling agent, a UV absorber, a foaming agent, an antioxidant, a colorant, a thermal stabilizer and a flame retardant, to the extent that does not impair the effects of the present disclosure.

[Method for producing the resin composition]

The resin composition of the present disclosure can be obtained by mixing the above-described hollow particles, the matrix resin, and other components which are added as needed. The method for mixing them is not particularly limited. For example, they can be mixed by use of a known mixing device such as a planetary mixer, a ball mill, a bead mill, a planetary mixer and a roll mill. The resin composition of the present disclosure obtained by use of such a mixing device is generally a resin composition in a liquid form (a resin varnish).

[Applications of the resin composition]

As the applications of the resin composition of the present disclosure, examples include, but are not limited to, materials such as a low dielectric material, a heat insulation material, a sound insulation material, a light reflective material, an antiglare film and a light diffusion material **(e.g.,** a light diffusion film or plate), which are used in various kinds of fields such as the automotive field, the electronics field, the electric field, the architecture field, the aviation field and the space field, food containers, footwears such as sports shoes and sandals, components of household appliances, components of bicycles, stationery supplies, tools, filaments of 3D printers, and floating buoyant materials such as syntactic foam. Especially because the resin composition of the present disclosure is excellent in dielectric property and reliability, it is preferably used in the electric or electronics field. For example, the resin composition of the present disclosure is preferably used as an electronic circuit board material. Also, the resin composition of the present disclosure is preferably used as a semiconductor material such as an interlayer insulation material, a dry film resist, a solder resist, a bonding wire, a magnet wire, a semiconductor encapsulating material, an epoxy encapsulating material, a molded underfill material, an underfill material, a die bonding paste, a buffer coating material, a copper-clad laminate and a flexible substrate, or it is preferably used as a semiconductor material for use in a high frequency device module, an antenna module, an automotive radar and so on. Of them, the resin composition of the present disclosure is particularly preferably used as a semiconductor material such as an interlayer insulation material, a solder resist, a magnet wire, a semiconductor encapsulant, an epoxy encapsulating material, an underfill material, a buffer coating material, a copper-clad laminate and a flexible substrate, or it is particularly preferably used as a semiconductor material for use in a high frequency device module, an antenna module, an automotive radar and so on. The resin composition of the present disclosure is applicable to not only semiconductor materials but also various kinds of electronic materials.

Also, the resin composition of the present disclosure is preferably used in an insulating resin sheet that is used for the production of electronic parts such as a printed circuit board. The insulating resin sheet can be produced as follows: the resin composition of the present disclosure is formed into a sheet by, for example, applying the composition to one or both surfaces of a sheet-shaped substrate and drying the applied composition, by extrusion molding of the composition, or by transferring the composition, thereby producing the insulating resin sheet. When the resin or elastomer contained in the insulating resin sheet is adhesive, the insulating resin sheet can be used as an adhesive sheet. More specifically, it can be used as a bonding sheet, for example. A bonding sheet is a material for forming insulating adhesive layers which are used to attach a conductor layer and an organic insulating layer in the production of a multi-layer printed circuit board.

**2.** Resin structure

The resin structure of the present disclosure contains the semi-cured or cured product of the resin composition of the present disclosure described above, and at least some of the hollow particles in the semi-cured or cured product are cross-linked to the matrix resin. When curing the resin structure, generally, when curing the thermosetting resin, the curing is preferably performed in an inert atmosphere. By curing the resin in an inert atmosphere, a change in dielectric property can be suppressed.

The resin structure of the present disclosure is formed from the resin composition of the present disclosure in a condition such that at least part of the reactive unsaturated bond of the hollow particles contained in the resin composition of the present disclosure reacts with the functional group of the matrix resin. For example, the resin structure of the present disclosure is obtained by heat-drying the resin composition of the present disclosure or by hot-pressing the resin composition of the present disclosure. Each of the prepreg described below, the insulation layer included in the metal foil-clad laminate described below, and the insulation layer included in the printed circuit board described below is the resin structure of the present disclosure; however, the resin structure of the present disclosure is not limited to them.

The resin structure of the present disclosure has properties such as a low dielectric dissipation factor, a low permittivity, lightweight and heat insulation, since it contains the hollow particles.

In the case of obtaining the resin structure by heat-drying the resin composition of the present disclosure, the heat-drying method is not particularly limited. For example, the resin composition can be heat-dried by use of an oven or the like. The heating temperature is not particularly limited. For example, it may be from 20°C to 200°C, from 50°C to 200°C, from 100°C to 180°C, or from 150°C to 170°C. The heating time is not particularly limited. For example, it may be from 1 minute to 1 hour, from 1 minute to 30 minutes, or from 3 minutes to 10 minutes. Also, the resin composition can be heat-dried in stages by gradually changing the heating temperature.

In the case of obtaining the resin structure by hot-pressing the resin composition of the present disclosure, the hot-pressing method is not particularly limited. For example, the resin composition can be hot-pressed by use of a hot press machine. The hot-pressing temperature, pressure and time are not particularly limited, and they can be appropriately set depending on the thickness of the metal foil-clad laminate to be produced, the composition of the resin composition of the prepreg to be produced, etc. For example, the temperature may be set to a range of from 150°C to 250°C or from 70°C to 220°C; the pressure may be set to a range of from 1.0 MPa to 7.0 MPa or from 1.5 MPa to 5.0 MPa; and the temperature may be set to a range of from 1 minute to 5 hours or from 1 hour to 3 hours.

The form of the resin structure of the present disclosure is not particularly limited, and it may be any kind of formable form. For example, the resin structure may be in a sheet form, a film form or a plate form, or it may be in any form such as a tube form and various kinds of other three-dimensional forms.

The resin structure of the present disclosure may be a structure obtained by adding the hollow particles of the present disclosure to a fiber reinforced plastic. The reinforcing fibers used in the fiber reinforced plastic is not particularly limited. As the reinforcing fibers, for example, known organic or inorganic reinforcing fibers such as carbon fibers, glass fibers, aramid fibers, polyethylene fibers, cellulose nanofibers and liquid crystal polymer (LCP) fibers. The reinforcing fibers contained in the resin structure of the present disclosure may be reinforcing fibers used as the substrate of a prepreg, or they may be reinforcing fibers contained as a filler.

In the resin structure of the present disclosure, the content of the hollow particles is not particularly limited. The content of the hollow particles is preferably 10% by volume or more, and more preferably 20% by volume or more as the lower limit. On the other hand, it is preferably 70% by volume or less, and more preferably 60% by volume or less as the upper limit. When the content of the hollow particles is equal to or more than the lower limit value, excellent effects are exerted by the hollow particles, such as the effect of decreasing the dielectric dissipation factor, permittivity and weight of the resin structure and the effect of heat insulation. When the content of the hollow particles is equal to or less than the upper limit value, the matrix resin can be sufficiently contained in the resin structure; therefore, a deterioration in the properties of the resin structure can be suppressed, and the mechanical strength can be increased.

In the resin structure of the present disclosure, the content of the matrix resin is not particularly limited. From the viewpoint of suppressing a deterioration in the properties of the resin structure and increasing the mechanical strength thereof, the content of the matrix resin is preferably 30% by volume or more, and more preferably 40% by volume or more. From the viewpoint of sufficiently containing the hollow particles, it is preferably 90% by volume or less, and more preferably 80% by volume or less.

When the matrix resin contained in the resin composition of the present disclosure is cured by an additive such as a crosslinking agent, the matrix resin contained in the resin structure of the present disclosure may contain an additive such as the crosslinking agent.

The dielectric dissipation factor of the resin structure of the present disclosure at a frequency of 10 GHz, is preferably $4.00 \times 10^{-3}$ or less, more preferably $3.00 \times 10^{-3}$ or less, and still more preferably $2.00 \times 10^{-3}$ or less. The lower limit of the dielectric dissipation factor is not particularly limited, and it may be $1.00 \times 10^{-4}$ or more, for example.

The relative permittivity of the resin structure of the present disclosure at a frequency of 10 GHz, is preferably 2.50 or less, more preferably 2.30 or less, and still more preferably 2.20 or less. The lower limit of the relative permittivity is not particularly limited, and it may be 1.00 or more, for example.

In the present disclosure, the relative permittivity and dielectric dissipation factor of the resin structure are measured by use of a perturbation-type measuring device.

3. Prepreg

The prepreg of the present disclosure is a prepreg obtained by impregnating a substrate with the resin composition of the present disclosure described above and heat-drying the substrate. The prepreg of the present disclosure contains a semi-cured product of the resin composition of the present disclosure described above, and at least some of the hollow particles in the semi-cured product are cross-linked to the matrix resin.

The substrate used to produce the prepreg is not particularly limited. As the substrate, examples include, but are not limited to, a substrate comprising inorganic fibers such as carbon fibers, glass fibers, metal fibers and ceramic fibers, or organic synthetic fibers such as polyamide fibers, polyester-based fibers, polyolefin-based fibers and novoloid fibers. The form of the substrate is not limited and may be a woven fabric, a non-woven fabric or the like. From the viewpoint of mechanical strength and so on, a glass cloth (glass fibers) is preferred.

As for the thickness of the substrate, for example, a substrate having a thickness of from 0.04 mm to 0.3 mm may be generally used.

The method for impregnating the substrate with the resin composition is not particularly limited. As the method, examples include, but are not limited to, a method of immersing the substrate in the resin composition and a method of applying the resin composition to the substrate. As needed, the impregnation may be repeated several times.

The heat-drying method is only required to be a method by which the matrix resin is put in a semi-cured state (the B-stage state). It may be the same as the heat-drying method for obtaining the resin structure described above.

4. Metal foil-clad laminate

The metal foil-clad laminate of the present disclosure is a metal foil-clad laminate comprising an insulation layer comprising a cured product of the resin composition of the present disclosure and a substrate, and a metal foil in contact with the insulation layer.

As the substrate included in the insulation layer, examples include, but are not limited to, those exemplified above as the substrate included in the above-described prepreg.

In the metal foil-clad laminate of the present disclosure, at least some of the hollow particles in the cured product of the resin composition contained in the insulation layer, are cross-linked to the matrix resin.

The metal foil-clad laminate of the present disclosure may be a metal foil-clad laminate obtained by hot-pressing a prepreg laminate which is a laminate of the prepregs of the present disclosure described above and a metal foil which is in contact with the prepreg laminate. In this case, a cured product of the prepreg laminate becomes the insulation layer. Hot-pressing the prepreg laminate and the metal foil which is in contact with the prepreg laminate, may be hot-pressing a laminate including the prepreg laminate and the metal foil which is in contact with the prepreg laminate.

In the metal foil-clad laminate of the present disclosure, the metal foil is only required to be in contact with at least one surface of the insulation layer, and the metal foil may be disposed on both surfaces of the insulation layer.

When the insulation layer is the cured product of the prepreg laminate, the number of the prepregs included in the prepreg laminate is not particularly limited. For example, the number of the prepregs included in the prepreg laminate may be 1 to 50, 2 to 40, 2 to 30, 2 to 20, or 2 to 10.

As the metal foil, examples include, but are not limited to, a copper foil, a silver foil and a gold foil. From the viewpoint of cost and electric conductivity, a copper foil is preferably used. The thickness of the metal foil is not particularly limited, and it may be from 9 $\mu$m to 70 $\mu$m, for example.

The hot-pressing method for obtaining the metal foil-clad laminate may be the same as the above-described hot-pressing method for obtaining the resin structure. By the hot-pressing method, the matrix resin contained in the insulation layer is completely cured.

In the metal foil-clad laminate of the present disclosure, the peel strength between the insulation layer and the metal foil is preferably 0.5 N/mm or more, more preferably 0.6 N/mm or more, and still more preferably 0.7 N/mm or more.

In the present disclosure, the peel strength between the insulation layer and the metal foil is measured according to JIS C 6481.

5. Printed circuit board

The printed circuit board of the present disclosure include the above-described metal foil-clad laminate of the present disclosure.

The printed circuit board of the present disclosure can be produced by, for example, forming a circuit on the above-described metal foil-clad laminate of the present disclosure. For example, the printed circuit board can be obtained by forming a conductor pattern by etching the metal foil on the metal foil-clad laminate. Also, a multilayer printed wiring board can be produced by using the printed circuit board as a core material.

Examples

Hereinbelow, the present disclosure is described more specifically using examples and comparative examples. However, the present disclosure is not limited to these examples. Also, "part (s)" and "%" are on a mass basis unless otherwise specified.

[Production Example 1]

1. Preparation of hollow particles

(1) Mixture liquid preparation step

First, the following materials were mixed to produce an oil phase.

Divinylbenzene (DVB) (a mixture of m-divinylbenzene and p-divinylbenzene) 37.2 parts

Ethylvinylbenzene (EVB) 1.5 parts
t-Butylperoxy diethylacetate 0.89 parts
Hydrophobic solvent (heptane) 61.3 parts

Next, in a stirring tank, an aqueous solution in which 13.72 parts of sodium hydroxide (an alkali metal hydroxide) was dissolved in 55 parts of deionized water, was gradually added under stirring to an aqueous solution in which 19.59 parts of magnesium chloride (a water-soluble polyvalent metal salt) was dissolved in 225 parts of deionized water, thereby preparing a magnesium hydroxide (sparingly water-soluble metal hydroxide) colloidal dispersion (magnesium hydroxide 10 parts). The dispersion was used as an aqueous phase.

The obtained aqueous phase and oil phase were mixed, thereby preparing a mixture liquid.

(2) Suspension step

The mixture liquid obtained in the mixture liquid preparation step was suspended with an emulsifying disperser (product name: HOMOMIXER, manufactured by PRIMIX Corporation) for one minute in the condition that the tip speed of the rotor was 88 m/s, thereby preparing a suspension in which droplets of a monomer composition including the hydrophobic solvent were dispersed in water.

(3) Polymerization step

In a nitrogen atmosphere, the temperature of the suspension obtained in the suspension step was increased to 80°C. The stirring power of the stirring blades was set to 0.04 kW/m$^3$, and the suspension was stirred for 24 hours, thereby performing a polymerization reaction. Accordingly, a precursor composition was obtained, which was a slurry solution in which precursor particles having a reactive unsaturated bond on the surface, were dispersed in water.

(4) Solvent removal step

The solvent removal step was carried out by the following procedure, using the stirring apparatus as shown in FIG. 2. As the stirring tank, a stirring tank with a capacity of 3.6 L was used. The interior of the stirring tank when supplying the precursor composition was a nitrogen atmosphere.

First, 2.6 L of the precursor composition obtained in the polymerization step was supplied from the supply tank to the stirring tank. The stirring power of the stirring blades disposed in the interior of the stirring tank was set to 0.04 kW/m$^3$, and the temperature of the precursor composition was increased to 95°C, while stirring the precursor composition in the stirring tank. The pressure in the interior of the stirring tank was reduced to 40 kPa. Nitrogen was bubbled into the precursor composition for 15 hours by stirring the precursor composition in the stirring tank, while nitrogen was directly injected into the precursor composition at a flow rate of 10 L/min (the flow rate per unit volume was 10,000 L/(min·m$^3$) since the vapor phase was 1 L) from the gas inlet on the bottom of the stirring tank (the gas inlet 13a in FIG. 2) toward the direction opposite to the direction of the force of gravity. During the bubbling, the cycle of stirring the fed precursor composition in the stirring tank, discharging the precursor composition to the supply tank, and then supplying again the precursor composition from the supply tank to the stirring tank, was repeated to circulate the precursor composition in the stirring apparatus. Also, during the bubbling, a part of the fed precursor composition was supplied from the stirring tank to the spray mechanism and continuously sprayed to the liquid surface of the precursor composition in the stirring tank. Accordingly, the aqueous dispersion of the hollow particles in which the hollow portion was filled with nitrogen, was obtained.

(5) Washing step

The aqueous dispersion of the hollow particles obtained in the solvent removal step was mixed with dilute sulfuric acid in an environment at 25°C and stirred for 10 minutes, thereby obtaining a pH-controlled slurry in which the pH was controlled to 5.5 or less. Keeping the temperature at 25°C, the pH-controlled slurry was subjected to pressure filtration and dehydrated, thereby obtaining a dehydrated cake of the hollow particles. A series of the following operations was repeated 6 times: washing the obtained dehydrated cake with 400 parts of deionized water, subjecting the washed cake to pressure filtration, and dehydrating the cake.

(6) Drying step

After the washing step, the dehydrated cake (water content 67%, thickness 2 cm) was preliminary dried using a dryer at a temperature of 40°C. Then, the cake was heated for 12 hours using a vacuum dryer under a vacuum condition at 200°C and 4 kPa, thereby removing the residual water from the particles. Accordingly, the hollow particles 1 of Production Example 1 were obtained.

[Production Example 2]

The hollow particles 2 of Production Example 2 were produced in the same manner as Production Example 1, except for the following: in "(1) Mixture liquid preparation step", the amount of the added DVB and that of the added EVB were changed according to Table 1; moreover, "(3) Polymerization step", the first polymerization reaction was performed by increasing the temperature to 80°C in the nitrogen atmosphere and stirring the suspension for one hour with a stirring power of the stirring blades of 0.04 kW/m$^3$, and then the second polymerization reaction was performed by adding 2.0 parts of allyl methacrylate (solubility in water at 20°C: 2.2 g/L) to the stirring tank and stirring the suspension for 23 hours in the same condition as the first polymerization reaction.

[Production Example 3]

The hollow particles 3 of Production Example 3 were produced in the same manner as Production Example 2, except that the first polymerization reaction was performed for 0.5 hours, and the second polymerization reaction was performed for 23.5 hours.

[Production Examples 4 to 10]

The hollow particles 4 to 10 of Production Examples 4 to 10 were produced in the same manner as Production Example 1, except that in "(1) Mixture liquid preparation step", the type and amount of the added polymerizable monomer were changed according to Table 1.
In Table 1, "Before suspension" under "Timing of addition" means that the allyl methacrylate was added to the oil phase in the above-described "(1) Mixture liquid preparation step".

<Measurement of polymerization conversion rate>

In the polymerization step of Production Examples 2 and 3, 50 g of the suspension just before adding the crosslinkable monomer (allyl methacrylate) was taken. After the pH of the taken suspension was adjusted to 5 to 6, the suspension was subjected to pressure filtration, thereby separating a polymer precipitate (containing water and the hydrophobic solvent) from the suspension. By drying the precipitate at 200°C for 2 hours, water and the hydrophobic solvent were removed therefrom. Then, the mass of the polymer precipitate was weighed precisely and used as the mass of the polymerizable monomer contained in the suspension (the total mass of the polymerized polymerizable monomer and the unreacted polymerizable monomer). The polymer precipitate was dispersed in ethyl acetate to obtain a dispersion, and 2 $\mu$L of the obtained dispersion was collected as a measurement sample. Next, the mass of the unreacted polymerizable monomer in the measurement sample was quantified by gas chromatography (GC) in the following condition, and the mass of the unreacted polymerizable monomer contained in the suspension was calculated. The polymerization conversion rate was calculated by the following formula (VI) from the mass of the polymerizable monomer contained in the suspension (that is, the mass of the polymer precipitate) and the mass of the unreacted polymerizable monomer contained in the suspension (that is, the mass of the unreacted polymerizable monomer measured by GC).
In the case where the polymer precipitate was not produced, after the pH of the suspension was adjusted to 5 to 6, the suspension was separated into two phases, and the oil phase was isolated. Next, 2 $\mu$L of the obtained oil phase was collected as a measurement sample. Next, each of the polymerized and unreacted polymerizable monomers in the measurement sample was quantified by gas chromatography (GC) in the following condition, and the mass of each of the polymerized and unreacted polymerizable monomers contained in the oil phase, was calculated. At this time, by dividing the non-reactive included solvent (hydrophobic solvent) contained in the oil phase, only the mass of the unreacted polymerizable monomer contained in the oil phase was able to be calculated. The polymerization conversion rate was calculated by the following formula (VI), using the mass of the polymerizable monomer contained in the suspension (that is, the total mass of the polymerized polymerizable monomer and unreacted polymerizable monomer contained in the suspension) and the mass of the unreacted polymerizable monomer contained in the suspension.

Polymerization conversion rate (% by mass) = 100 - (Mass of the unreacted polymerizable monomer/ Mass of the polymerizable monomer contained in the suspension) $\times$ 100      Formula (VI)

(Condition of GC)

Column: TC-WAX (0.25 mm $\times$ 30 m)
Column temperature: 80°C
Injection temperature: 200°C
FID detection side temperature: 200°C

[Comparative Production Example 1]

Comparative Production Example 1 corresponds to Example 1 of Patent Document 1.

An emulsified liquid was obtained by mixing pure water, 0.25 parts of sodium dodecylbenzene sulfonate, 50 parts of divinylbenzene, 50 parts of hexadecane and 3 parts of benzoyl peroxide.

The emulsified liquid was put in a separable flask. In a nitrogen atmosphere, the temperature of the emulsified liquid was increased to 70°C, and the emulsified liquid was polymerized at 70°C for 9 hours.

Next, a dispersion was produced by mixing 1.25 parts of benzoyl peroxide, 17 parts of toluene, 0.09 parts of sodium dodecylbenzene sulfonate, and pure water. The dispersion was divided into three. First, one-third of the dispersion was charged into the reaction solution in the separable flask. After a lapse of 1.5 hours, another one-third of the dispersion was charged into the reaction solution in the separable flask. After a lapse of another 1.5 hours, the remaining one-third of the dispersion was charged into the reaction solution in the separable flask. Then, the reaction solution was polymerized by stirring the solution for two hours, thereby obtaining core-shell particles in a latex form.

Then, 100 parts of the obtained core-shell particles in the latex form and 100 parts of acetone were charged into another separable flask. The mixture was stirred for 5 minutes at room temperature and then stirred for 30 minutes at 40°C. After the end of the stirring, the reaction solution in the separable flask was left to stand, thereby separating the solution into an aggregated particle layer and a transparent solvent layer. The layers were subjected to natural filtration using a filter paper. The aggregated particles thus collected were further dispersed in a mixed solvent of acetone and hexane, and the mixed solvent was stirred for 30 minutes at 40°C. After the end of the stirring, the mixed solvent was left to stand, thereby separating the solvent into an aggregated particle layer and a transparent solvent layer. The layers were subjected to natural filtration using a filter paper. The aggregated particles thus collected were dispersed in acetone to substituted the hexadecane in the core of the particles by an organic solvent having a low boiling point, thereby obtaining an acetone dispersion in which hollow particles, which included the organic solvent in the core, were dispersed.

With respect to 100 parts of the acetone dispersion, 526 parts of methyl ethyl ketone was added. The mixture was devolatilized under reduced pressure at 70°C for removal of the acetone and hexane used above, thereby obtaining a methyl ethyl ketone dispersion in which the hollow particles were dispersed.

Then, 250 parts of pure water was added to and mixed with 100 parts of the methyl ethyl ketone dispersion. The thus-obtained mixture was left to stand, thereby separating the mixture into aggregated particles and a transparent solvent. The particles and the solvent were separated from each other by filtration using a gauze. Pure water was added to and mixed with the aggregated particles. After methyl ethyl ketone was added to the mixture, the mixture was stirred and then left to stand, thereby separating the mixture into aggregated particles and a transparent solvent. The particles and the solvent were separated from each other by filtration using a gauze. Methyl ethyl ketone was added to the collected aggregated particles, thereby obtaining a methyl ethyl ketone dispersion in which the hollow particles were dispersed.

Next, the methyl ethyl ketone dispersion was transferred to a recovery flask, and 264 parts of methyl ethyl ketone was added to 100 parts of the methyl ethyl ketone dispersion. The mixture was devolatilized under reduced pressure at 70°C for removal of the pure water used above, thereby obtaining a methyl ethyl ketone dispersion in which the hollow particles were dispersed. The methyl ethyl ketone dispersion was dried, thereby obtaining the hollow particles C1 of Comparative Production Example 1.

[Table 1]

Table 1

| | | | Production Example 1 | Production Example 2 | Production Example 3 | Production Example 4 | Production Example 5 | Production Example 6 | Production Example 7 | Production Example 8 | Production Example 9 | Production Example 10 | Comparative Production Example 1 |
|---|---|---|---|---|---|---|---|---|---|---|---|---|---|
| | | | Hollow particles 1 | Hollow particles 2 | Hollow particles 3 | Hollow particles 4 | Hollow particles 5 | Hollow particles 6 | Hollow particles 7 | Hollow particles 8 | Hollow particles 9 | Hollow particles 10 | Hollow particles C1 |
| Polymerizable monomer | | Divinylbenzene (parts) | 37.2 | 35.2 | 35.2 | 35.2 | 29.7 | 26.1 | 23.1 | 28.5 | 26.1 | 22.1 | 50 |
| | | Diethylbenzene (parts) | 1.5 | 1.5 | 1.5 | 1.5 | 7.0 | 10.6 | 13.6 | 1.2 | | 16.6 | |
| | | Styrene (parts) | | | | | | | | 5.6 | 10.6 | | |
| | Allyl methacrylate | (parts) | | 2 | 2 | 2 | | | | | | | |
| | | Polymerization conversion rate (%) at the time of addition | | 50 | 15 | 0 | | | | | | | |
| | | Timing of addition | | When 1 hour passed after reaching 80°C | When 0.5 hours passed after reaching 80°C | Before suspension | | | | | | | |
| | | Crosslinkable monomer (%) | 96.1 | 96.1 | 96.1 | 96.1 | 80.9 | 71.1 | 62.9 | 80.7 | 71.1 | 57.1 | 100 |
| | | Hydrocarbon monomer (%) | 100 | 94.8 | 94.8 | 94.8 | 100 | 100 | 100 | 100 | 100 | 100 | 100 |
| Hydrophobic solvent | | Heptane (parts) | 61.3 | 61.3 | 61.3 | 61.3 | 61.3 | 61.3 | 61.3 | 61.3 | 61.3 | 61.3 | |
| | | Hexadecane (parts) | | | | | | | | | | | 50 |
| Polymerization initiator | | t-Butylperoxy diethylacetate (parts) | 0.89 | 0.89 | 0.89 | 0.89 | 0.89 | 0.89 | 0.89 | 0.89 | 0.89 | 0.89 | |
| | | Benzoyl peroxide (parts) | | | | | | | | | | | 4.25 |
| Dispersion stabilizer | | $Mg(OH)_2$ (parts) | 10 | 10 | 10 | 10 | 10 | 10 | 10 | 10 | 10 | 10 | |
| | | Sodium dodecylbenzene sulfonate (parts) | | | | | | | | | | | 0.34 |

[Measurement and evaluation of the hollow particles]

The hollow particles obtained in the above examples were measured and evaluated as follows. The results are shown in Tables 2 and 3. In the following tables, for simplification, the dielectric dissipation factor values and the thermal expansion coefficient values are expressed by using the exponent notation defined in JIS X 0210. For example, the term "$5.60 \times 10^{-4}$" is expressed as "5.60E-04".

1. Observation of the hollow particles

The hollow particles were fixed on a carbon tape. The fixed hollow particles were intentionally broken by rubbing them with a cotton swab. The interior of 100 of the broken particles was observed by SEM. The number of hollow portions per particle was specified, and the percentage (%) of the number of particles having only one hollow portion was calculated.

2. Percentage of irregular-shaped particles

A mixed solution was obtained by adding 0.10 g to 0.12 g of the hollow particles to a linear alkylbenzene sulfonate aqueous solution (concentration 0.3%) and subjected to a dispersion treatment for 5 minutes by an ultrasonic cleaner, thereby preparing a measurement sample. Using a flow particle image analyzer (product name: IF-3200, manufactured by JASCO International Co., Ltd.), the particles contained in the measurement sample were measured for circularity in the following measurement conditions. The percentage by mass of the particles having a circularity of 0.85 or less was calculated and defined as the percentage of the irregular-shaped particles.

The number of the particles contained in the measurement sample increased as the particle diameter decreased. In all of the Examples and the Comparative examples, the number of the contained particles was within a range of from 1000 to 3000.

(Measurement conditions)

Thickness of the spacer of a flow cell: 50 $\mu$m
Telecentric zoom lens magnification: 4.5 x
Total magnification: 9.0 x
Measured amount: 0.5 mL
Image resolution: 0.185 $\mu$m/pixel
Detection algorithm: Ghost detection
Threshold: 15%

**3.** Particle diameter and particle size distribution

The particle diameter of the hollow particles was measured by use of a particle size distribution measuring device by the Coulter counter method (product name: MULTISIZER 4e, manufactured by Beckman Coulter, Inc.) Then, the number average and the volume average were calculated therefrom to obtain the number average particle diameter (Dn) and the volume average particle diameter (Dv). By dividing the volume average particle diameter by the number average particle diameter, the particle size distribution (Dv/Dn) of the hollow particles was obtained.

The measurement conditions were as follows.
Aperture diameter: 50 $\mu$m
Dispersion medium: ISOTON II (product name)
Concentration: 10%
Number of the measured hollow particles: 100,000 particles

More specifically, 0.2 g of the sample hollow particles were put in a beaker. As a dispersant, a surfactant aqueous solution (product name: DRIWEL, manufactured by Fujifilm Corporation) was added thereto. In addition, 2 mL of the dispersion medium was added to wet the hollow particles. Then, 10 mL of the dispersion medium was added thereto. The mixture was dispersed for one minute with an ultrasonic disperser. Then, the measurement with the above-described particle size measuring device was carried out.

4. Void ratio

4-1. Measurement of apparent density of hollow particles

First, approximately 30 $cm^3$ of the hollow particles were introduced into a measuring flask with a volume of 100 $cm^3$, and the mass of the introduced hollow particles was precisely weighed. Next, the measuring flask in which the hollow particles were introduced, was precisely filled with isopropanol up to the marked line while care was taken so that air bubbles did not get in. The mass of the isopropanol added to the measuring flask was precisely weighed, and the apparent density $D_1$ ($g/cm^3$) of the hollow particles was calculated by the following formula (I).

Apparent density $D_1$ = [Mass of the hollow particles]/ (100 - [Mass of the isopropanol]/[Specific gravity of the isopropanol at the measuring temperature])          Formula (I)

4-2. Measurement of the true density of the hollow particles

The hollow particles were pulverized in advance; approximately 10 g of the pulverized hollow particles were introduced into a measuring flask with a volume of 100 $cm^3$; and the mass of the introduced pulverized particles were precisely weighed.

Then, similarly to the measurement of the apparent density mentioned above, isopropanol was added to the measuring flask; the mass of the isopropanol was precisely weighed; and the true density $D_0$ ($g/cm^3$) of the hollow particles was calculated by the following formula (II).

True density $D_0$ = [Mass of the pulverized hollow particles]/(100 - [Mass of the isopropanol]/[Specific gravity of the isopropanol at the measuring temperature])          Formula (II)

4-3. Calculation of void ratio

The void ratio of the hollow particles was calculated by the following formula (III), using the apparent density $D_1$ and the true density $D_0$.

Void ratio (%) = 100 - (Apparent density $D_1$/True density $D_0$) $\times$ 100          Formula (III)

5. Measurement of the relative permittivity (Dk) and dielectric dissipation factor (Df) of the hollow particles

Using a perturbation-type measuring device (manufactured by: AET Inc., model: ADMS01Nc), the relative permittivity and dielectric dissipation factor of the hollow particles were measured at a frequency of 10 GHz, a temperature of 23°C and a humidity of 50%.

6. Measurement of unsaturated bond amount

6-1. Measurement of iodine value

The iodine value of the hollow particles was measured in accordance with JIS K 0070. The details of the measurement method were as follows.

First, 0.7 g to 2 g of the hollow particles and 10 mL of chloroform were put in a 300 mL iodine flask. In addition, 25 mL of Wijs reagent was added thereto as a reaction solution. After lightly stirring the mixture, the flask was sealed and then left to stand for 60 minutes in a dark place at 25°C. Next, 20 mL of a 100 g/L potassium iodide solution and 100 mL of purified water were added thereto, and the mixture was stirred. Titration was carried out by use of a buret and a titrant (a 0.1 mol/L sodium thiosulfate solution). An indicator (a 1% starch solution) was added when the solution turned light yellow. The titration was continued until the blue color disappeared, and this point of time was regarded as the endpoint. Separately from this main test, a blank test was performed on a solution that was free of the hollow particles, and the iodine value of the hollow particles was calculated by the following formula. The iodine value is a value obtained as follows: halogen is reacted with 100 g of a sample, and the amount of halogen thus binding to the sample is converted to the grams of iodine, thereby obtaining the iodine value.

$$\text{Iodine value (g/100 g)} = \{(V_0 - V_1) \times f \times 1.269\} / S$$

S: Mass (g) of the sample
$V_1$: Titrant amount (mL) in the main test
$V_0$: Titrant amount (mL) in the blank test
f: Factor of the titrant

6-2. Measurement of specific surface area

The specific surface area ($m^2/g$) of the hollow particles was obtained by the following formula (B), using the above-measured volume average particle diameter and apparent density $D_1$ of the hollow particles.

Specific surface area ($m^2/g$) = 6/(Volume average particle diameter (m) × Apparent density $D_1$ ($g/m^3$))　　　Formula (B)

6-3. Calculation of unsaturated bond amount

The unsaturated bond amount ($mmol/m^2$) of the hollow particles was calculated by the following formula (A), using the specific surface area of the hollow particles and the value obtained by converting the above-measured iodine value (g/100 g) of the hollow particles to the iodine value (mmol/g).

Unsaturated bond amount ($mmol/m^2$) = Iodine value (mmol/g) /Specific surface area ($m^2/g$)　　　Formula (A)

In accordance with Rule B of JIS Z 8401:1999, values rounded to three decimal places were used as the iodine value and the specific surface area. The unsaturated bond amount was a value rounded to three decimal places.

7. Thermal expansion coefficient

7-1. Production of formed plate for measurement

First, 50 parts of epoxy resin (manufactured by Daicel Corporation, product name: EHPE3150CE), 24.9 parts of a curing agent (manufactured by DIC Corporation, product name: LF6161), 0.1 parts of 2-ethyl-4-methylimidazole (2E4MZ, manufactured by Nacalai Tesque, Inc.) as a curing catalyst, and 26 parts of methyl ethyl ketone (MEK) were mixed. The mixture was stirred for 30 minutes. After stirring the mixture, 16.6 parts of the hollow particles were added to the mixture, and the mixture was further stirred for one hour, thereby producing a resin composition. Next, 15 g of the resin composition was placed on a copper foil and defoamed with a vacuum dryer at 130°C until no bubble was formed. Then, the defoamed resin composition was cured in a hot air circulation oven at 110°C for two hours. By use of a pressing machine, heat-pressing of the cured product of the resin composition was started at 110°C and a pressure of 0.5 MPa, and then the temperature was increased to 205°C (4°C/min) and kept for one hour, thereby producing a formed plate. The formed plate was cut into a size of 20 mm × 40 mm × 0.5 mm, thereby obtaining a measurement sample.

7-2. Measurement of the thermal expansion coefficient of the hollow particles

In accordance with JIS K 7197:2012, using a TMA device (manufactured by Rigaku Corporation, model: TMA-8311), the thermal expansion coefficient of the produced formed plate in a range of from 23°C to 250°C was measured in tensile mode.

The thermal expansion coefficient $\alpha_p$ of the hollow particles in a temperature range of from 23°C to 100°C was calculated by the following formula (IV):

$$\alpha_p = (\alpha_c - SG_r \times \alpha_r) / W_p \quad \text{Formula (IV)}$$

(where $\alpha_c$ is the thermal expansion coefficient of the formed plate; $\alpha_r$ is the thermal expansion coefficient of the epoxy resin alone; $SG_r$ is the volume ratio of the epoxy resin in the formed plate; and $W_p$ is the volume ratio of the hollow particles in the formed plate.)

8. Electric conductivity of the aqueous dispersion of the hollow particles

A non-ionic surfactant (product name: SN DEFOAMER 180, manufactured by: San Nopco Limited, a polyether-based surfactant) was dissolved at a concentration of 0.1% by mass in deionized water to obtain an aqueous solution (electric conductivity: 1 μS/cm or less). To 100 mL of the aqueous solution, the hollow particles with a volume of 0.35 $cm^3$

were added. At 25°C, the aqueous solution was stirred for three hours at 300 rpm, thereby obtaining an aqueous dispersion of the hollow particles. The obtained aqueous dispersion of the hollow particles was measured for electric conductivity. By visual confirmation, the obtained aqueous dispersion of the hollow particles was found to be in such a state, that powder was not present in the upper part and was entirely dispersed in the water. As the hollow particles with a volume of 0.35 cm$^3$, the hollow particles having the weight (g) obtained by the following formula (V) were weighed out, collected and used.

$$\text{Weight (g) of the hollow particles with a volume of 0.35 cm}^3 = \text{Apparent density } D_1 \text{ (g/cm}^3) \text{ of the hollow particles} \times 0.35 \text{ (cm}^3) \qquad \text{Formula (V)}$$

9. Residual metal amount

Wet digestion of the weighed hollow particles (10 g) was carried out by use of a microwave (MULTIWAVE 3000 manufactured by PerkinElmer Inc.) ICP optical emission spectroscopy of the thus-obtained degradation product was carried out by use of an ICP optical emission spectrometer (OPTIMA 2100 DV manufactured by PerkinElmer Inc.) to measure the total mass of the metal. The metal species was specified by elemental analysis by X-ray fluorescence spectrometry (XRF). The ratio of the total mass of the metal in the degradation product with respect to the mass of the hollow particles, was calculated and regarded as the residual metal amount in the hollow particles.

[Example 1]

(1) Preparation of resin composition

First, 100 parts of a solution of 65% modified polyphenylene ether (modified PPE) in toluene, which was modified by a functional group including a vinyl group (product name: OPE-1200, manufactured by: Mitsubishi Gas Chemical Company, Inc., iodine value: 43 g/100 g, number average molecular weight: 1200), was weighed in a cup. Next, 11 parts of the hollow particles 1 obtained in Production Example 1 and 0.63 parts of dicumyl peroxide (product name: PERCUMYL D, manufactured by: NOF Corporation) were added thereto and uniformly dispersed by a planetary centrifugal mixer (product name: MAZERUSTAR, manufactured by: Kurabo Industries Ltd.), thereby preparing the resin composition of Example 1.

(2) Production of resin film

An aluminum foil was attached to a glass plate without shrinkage. On the attached aluminum foil, the resin composition obtained in the above (1) was applied by use of bar coater No. 75 to form a coating film. Under a nitrogen atmosphere, the coating film was cured by heating at 80°C for one hour, 120°C for 30 minutes, 160°C for 30 minutes, and then 200°C for one hour, thereby forming a resin film on the aluminum foil. The thus-obtained laminate of the resin film and the aluminum foil was immersed overnight in a 1 N hydrochloric acid aqueous solution to remove the aluminum foil, thereby obtaining the resin film only. The obtained resin film was washed with deionized water and dried, thereby obtaining a resin film. The content of the hollow particles in the obtained resin film was 40% by volume with respect to 100% by volume of the resin film.

(3) Production of prepreg

A glass cloth (product name: WEA116E, manufactured by: Nitto Boseki Co., Ltd.) was impregnated with the resin composition obtained in the above (1). Then, the solvent was removed therefrom by heat-drying the cloth at a temperature of from 150°C to 170°C for 3 minutes to 10 minutes, thereby obtaining a prepreg. The obtained prepreg contained a semi-cured product of the resin composition, and the content of the hollow particles in the semi-cured product was 40% by volume with respect to 100% by volume of the semi-cured product.

(4) Production of metal foil-clad laminate

A copper foil having a thickness of 18 μm was disposed on both sides of the prepreg obtained above. They were hot-pressed and formed in the curing conditions of a temperature of 200°C and a pressure of 2.94 MPa (30 kg/cm$^2$) for two hours, thereby obtaining a double-sided copper clad laminate having a thickness of 0.10 mm, which included a cured product of the prepreg and the copper foil disposed on both surfaces of the cured product.

[Examples 2 to 10 and Comparative Example 1]

The resin composition, resin film, prepreg and metal foil-clad laminate of Examples 2 to 10 and Comparative Example 1 were produced in the same manner as Example 1, except that the hollow particles 2 to 10 obtained in Production Examples 2 to 10 or the hollow particles C1 obtained in Comparative Production Example 1 were used instead of the hollow particles 1 obtained in Production Example 1.

[Comparative Example 2]

The resin composition, resin film, prepreg and metal foil-clad laminate of Comparative Example 2 were produced in the same manner as Example 1, except that the hollow particles were not added to the resin composition.

[Comparative Example 3]

The resin composition, resin film, prepreg and metal foil-clad laminate of Comparative Example 3 were produced in the same manner as Example 1, except that silica particles manufactured by Admatechs Company Ltd. (product name: SC2500-SXJ) were used instead of the hollow particles 1 obtained in Production Example 1.

[Comparative Example 4]

The resin composition, resin film, prepreg and metal foil-clad laminate of Comparative Example 4 were produced in the same manner as Example 1, except that hollow glass particles manufactured by Taiheiyo Cement Corporation (product name: CELLSPHERES (registered trademark) NF) were used instead of the hollow particles 1 obtained in Production Example 1.

[Comparative Example 5]

The resin composition, resin film, prepreg and metal foil-clad laminate of Comparative Example 5 were produced in the same manner as Example 1, except that hollow urethane particles manufactured by Negami Chemical industrial Co., Ltd. (product name: H-600T) were used instead of the hollow particles 1 obtained in Production Example 1.

[Example 11]

A modified polyphenylene ether (modified PPE) modified by a methacryloyl group (product name: NORYL SA9000, manufactured by: Saudi Basic Industries Corporation (SABIC), iodine value: 29 g/100 g, number average molecular weight: 1700) was dissolved in toluene to a concentration of 50%. Next, 100 parts of the thus-obtained solution was weighed in a cup. Then, 8.7 parts of the hollow particles 1 obtained in Production Example 1 and 0.5 parts of dicumyl peroxide (product name: PERCUMYL D, manufactured by: NOF Corporation) were added thereto and uniformly dispersed by a planetary centrifugal mixer (product name: MAZERUSTAR, manufactured by: Kurabo Industries Ltd.), thereby preparing the resin composition of Example 11.
The resin film, prepreg and metal foil-clad laminate of Example 11 were obtained in the same manner as Example 1, except that the resin composition obtained above was used.
In the obtained resin film, the content of the hollow particles was 40% by volume with respect to 100% by volume of the resin film. In the obtained prepreg, the content of the hollow particles was 40% by volume with respect to 100% by volume of the semi-cured product of the resin composition.

[Comparative Example 6]

The resin composition, resin film, prepreg and metal foil-clad laminate of Comparative Example 6 were produced in the same manner as Example 11, except that the hollow particles were not added to the resin composition.

[Example 12]

First, 86 parts of a solution of 65% modified polyphenylene ether (modified PPE) in toluene, which was modified by a functional group including a vinyl group (product name: OPE-1200, manufactured by: Mitsubishi Gas Chemical Company, Inc., iodine value: 43 g/100 g, number average molecular weight: 1200), and 14 parts of triallyl isocyanurate (product name: TAIC, manufactured by: Mitsubishi Chemical Corporation, iodine value: 305 g/100 g) were weighed in a cup. Next, 12.3 parts of the hollow particles 1 obtained in Production Example 1 and 0.7 parts of dicumyl peroxide (product name: PERCUMYL D, manufactured by: NOF Corporation) were added thereto and uniformly dispersed by a planetary centrifugal mixer (product name: MAZERUSTAR, manufactured by: Kurabo Industries Ltd.), thereby preparing the resin composition of Example 12.

The resin film, prepreg and metal foil-clad laminate of Example 12 were obtained in the same manner as Example 1, except that the resin composition obtained above was used.

In the obtained resin film, the content of the hollow particles was 40% by volume with respect to 100% by volume of the resin film. In the obtained prepreg, the content of the hollow particles was 40% by volume with respect to 100% by volume of the semi-cured product of the resin composition.

[Comparative Example 7]

The resin composition, resin film, prepreg and metal foil-clad laminate of Comparative Example 7 were produced in the same manner as Example 12, except that the hollow particles were not added to the resin composition.

[Example 13]

First, 100 parts of a solution of 70% maleimide resin in MEK (product name: MIR-3000-70MT, manufactured by: Nippon Kayaku Co., Ltd., number average molecular weight: 1200) was weighed in a cup. Next, 12.3 parts of the hollow particles 1 obtained in Production Example 1 and 0.7 parts of dicumyl peroxide (product name: PERCUMYL D, manufactured by: NOF Corporation) were added thereto and uniformly dispersed by a planetary centrifugal mixer (product name: MAZERUSTAR, manufactured by: Kurabo Industries Ltd.), thereby preparing the resin composition of Example 13.

The resin film, prepreg and metal foil-clad laminate of Example 13 were obtained in the same manner as Example 1, except that the resin composition obtained above was used.

In the obtained resin film, the content of the hollow particles was 40% by volume with respect to 100% by volume of the resin film. In the obtained prepreg, the content of the hollow particles was 40% by volume with respect to 100% by volume of the semi-cured product of the resin composition.

[Comparative Example 8]

The resin composition, resin film, prepreg and metal foil-clad laminate of Comparative Example 8 were produced in the same manner as Example 13, except that the hollow particles were not added to the resin composition.

[Evaluation of the resin film]

The resin film was cut to a size of 3 mm in width and 80 mm in length, thereby obtaining a measurement sample. In accordance with JIS R 1641, using a perturbation-type measuring device (manufactured by: AET Inc., model: ADMS01Nc), the relative permittivity and dielectric dissipation factor of the obtained measurement sample (the resin film) were measured at a frequency of 10 GHz, a temperature of 23°C and a humidity of 50%.

After the measurement, the measurement sample was immersed in deionized water at 25°C for 24 hours, and the deionized water was lightly wiped from the surface of the measurement sample with a paper towel. In the same manner as above, the relative permittivity and dielectric dissipation factor of the measurement sample were measured and regarded as the relative permittivity and dielectric dissipation factor of the resin film after the water absorption test.

The dielectric dissipation factor (Df) change amount before and after the water absorption test was calculated as follows.

Df change amount before and after the water absorption test = Df after the water absorption test - Df before the water absorption test

The physical properties of the resin films of Examples and Comparative Examples correspond to the physical properties of the insulation layer included in the metal foil-clad laminates of Examples and Comparative Examples.

[Evaluation of the metal foil-clad laminate]

(1) Copper foil peel strength

In accordance with JIS C 6481, the peel strength (N/mm) at the time of peeling the copper foil from the metal foil-clad laminate by a tensile tester at a speed of 50 mm/min, was measured.

(2) Reliability test

On the metal foil-clad laminate, a HAST test was carried out by use of a high accelerated stress test chamber (manufactured by ESPEC Corp.) at a temperature of 110°C and a humidity of 85% RH for 100 hours. After the test, a voltage of 50 V was applied to the metal foil-clad laminate for a predetermined time; the resistance of the laminate was measured; and the presence or absence of an abnormality was checked and evaluated in accordance with the following evaluation criteria. In the case where a change occurred in the resistance, it was regarded as "abnormal". The change in the resistance was considered to be due to ion migration.

(Evaluation criteria)

AA: No abnormality occurred even after the voltage was applied for 400 hours.

A: No abnormality occurred even after the voltage was applied for 300 hours; however, an abnormality occurred before the voltage applying time reached 400 hours.
B: No abnormality occurred even after the voltage was applied for 200 hours; however, an abnormality occurred before the voltage applying time reached 300 hours.
C: An abnormality occurred before the voltage applying time reached 200 hours.

[Table 2]

Table 2

| | | Example 1 | Example 2 | Example 3 | Example 4 | Example 5 | Example 6 | Example 7 | Example 8 | Example 9 | Example 10 |
|---|---|---|---|---|---|---|---|---|---|---|---|
| Particles | Type | Hollow particles 1 | Hollow particles 2 | Hollow particles 3 | Hollow particles 4 | Hollow particles 5 | Hollow particles 6 | Hollow particles 7 | Hollow particles 8 | Hollow particles 9 | Hollow particles 10 |
| | Percentage (%) of particles having one hollow portion | 100 | 99 | 99 | 99 | 99 | 99 | 99 | 98 | 100 | 98 |
| | Percentage (%) of irregular-shaped particles | 2.2 | 3.3 | 2.9 | 2.7 | 2.7 | 2.5 | 3.1 | 2.9 | 3 | 3.5 |
| | Dv ($\mu$m) | 2.6 | 3.0 | 3.0 | 3.0 | 2.9 | 3.4 | 3.2 | 4.1 | 2.8 | 3.1 |
| | Dn ($\mu$m) | 1.9 | 2.1 | 2.1 | 2.1 | 2.0 | 2.5 | 2.2 | 2.8 | 2.0 | 2.0 |
| | Dv/Dn | 1.37 | 1.43 | 1.43 | 1.43 | 1.45 | 1.36 | 1.45 | 1.46 | 1.40 | 1.55 |
| | Void ratio (%) | 70 | 70 | 70 | 70 | 70 | 70 | 70 | 70 | 70 | 70 |
| | Relative permittivity at 10 GHz | 1.36 | 1.37 | 1.37 | 1.37 | 1.36 | 1.36 | 1.36 | 1.36 | 1.36 | 1.36 |
| | Dielectric dissipation factor at 10 GHz | 5.60E-04 | 9.00E-04 | 8.80E-04 | 9.20E-04 | 4.20E-04 | 4.00E-04 | 3.80E-04 | 4.90E-04 | 4.30E-04 | 4.80E-04 |
| | Unsaturated bond amount (mmol/m$^2$) | 0.161 | 0.168 | 0.192 | 0.114 | 0.087 | 0.031 | 0.027 | 0.079 | 0.035 | 0.016 |
| | Thermal expansion coefficient (/°C) | 5.3E-05 | 5.4E-05 | 5.4E-05 | 5.5E-05 | 5.7E-05 | 6.0E-05 | 6.1E-05 | 5.5E-05 | 5.7E-05 | 5.9E-05 |
| | Electric conductivity ($\mu$S/cm) of aqueous dispersion | 8.1 | 7.4 | 7.4 | 7.4 | 9.9 | 8.1 | 7.0 | 5.6 | 2.8 | 10.1 |
| | Residual metal amount (ppm) | 14 | 30 | 30 | 30 | 22 | 31 | 30 | 44 | 19 | 22 |
| Matrix resin | Type | Modified PPE | Modified PPE | Modified PPE | Modified PPE | Modified PPE | Modified PPE | Modified PPE | Modified PPE | Modified PPE | Modified PPE |
| | Functional group reactive with particles | Vinyl group | Vinyl group | Vinyl group | Vinyl group | Vinyl group | Vinyl group | Vinyl group | Vinyl group | Vinyl group | Vinyl group |

(continued)

| | | Example 1 | Example 2 | Example 3 | Example 4 | Example 5 | Example 6 | Example 7 | Example 8 | Example 9 | Example 10 |
|---|---|---|---|---|---|---|---|---|---|---|---|
| Resin film | Relative permittivity (Dk) at 10 GHz | 1.91 | 1.92 | 1.92 | 1.92 | 1.91 | 1.91 | 1.91 | 1.91 | 1.91 | 1.91 |
| | Dielectric dissipation factor (Df) at 10 GHz | 1.69E-03 | 1.83E-03 | 1.83E-03 | 1.83E-03 | 1.63E-03 | 1.61E-03 | 1.61E-03 | 1.66E-03 | 1.64E-03 | 1.66E-03 |
| | Dk after water absorption test | 1.91 | 1.92 | 1.92 | 1.92 | 1.91 | 1.91 | 1.91 | 1.91 | 1.91 | 1.91 |
| | Df after water absorption test | 1.69E-03 | 1.84E-03 | 1.84E-03 | 1.84E-03 | 1.64E-03 | 1.64E-03 | 1.65E-03 | 1.68E-03 | 1.69E-03 | 1.72E-03 |
| | Df change amount before and after water absorption test | 2.00E-06 | 8.00E-06 | 8.00E-06 | 8.00E-06 | 8.00E-06 | 3.20E-05 | 4.00E-05 | 2.00E-05 | 5.40E-05 | 6.00E-05 |
| Metal foil-clad laminate | Copper foil peel strength (N/mm) | 0.7 | 0.8 | 0.7 | 0.7 | 0.7 | 0.5 | 0.5 | 0.6 | 0.5 | 0.5 |
| | Reliability test | AA | AA | AA | AA | AA | B | B | A | B | B |

[Table 3]

Table 3

| | | Comparative Example 1 | Comparative Example 2 | Comparative Example 3 | Comparative Example 4 | Comparative Example 5 |
|---|---|---|---|---|---|---|
| Particles | Type | Hollow particles C1 | - | Silica particles | Hollow glass particles | Hollow urethane particles |
| | Percentage (%) of particles having one hollow portion | 92 | - | 0 | 94 | 93 |
| | Percentage (%) of irregular-shaped particles | 9.9 | - | 6 | 8.8 | 5.3 |
| | Dv ($\mu$m) | 0.19 | - | 0.5 | 5.90 | 10.5 |
| | Dn ($\mu$m) | 0.1 | - | 0.3 | 3.01 | 5.7 |
| | Dv/Dn | 1.90 | - | 1.67 | 1.96 | 1.84 |
| | Void ratio (%) | 50 | - | 0 | 82 | 49 |
| | Relative permittivity at 10 GHz | 1.66 | - | 3.8 | 1.69 | 2.31 |
| | Dielectric dissipation factor at 10 GHz | 4.00E-03 | - | 1.10E-03 | 7.99E-03 | 1.02E-02 |
| | Unsaturated bond amount (mmol/m$^2$) | 0.056 | - | 0.016 | 0.003 | 0.002 |
| | Thermal expansion coefficient (/°C) | 6.6E-05 | - | 6.0E-07 | 3.0E-07 | 1.1E-04 |
| | Electric conductivity ($\mu$S/cm) of aqueous dispersion | 125.4 | - | 42.2 | 33.5 | 79 |
| | Residual metal amount (ppm) | 414 | - | 299 | 700 | 91 |
| Matrix resin | Type | Modified PPE | Modified PPE | Modified PPE | Modified PPE | Modified PPE |
| | Functional group reactive with particles | Vinyl group | - | Vinyl group | Vinyl group | Vinyl group |

(continued)

| | | Comparative Example 1 | Comparative Example 2 | Comparative Example 3 | Comparative Example 4 | Comparative Example 5 |
|---|---|---|---|---|---|---|
| Resin film | Relative permittivity (Dk) at 10 GHz | 2.03 | 2.28 | 2.89 | 2.04 | 2.29 |
| | Dielectric dissipation factor (Df) at 10 GHz | 3.06E-03 | 2.44E-03 | 1.90E-03 | 4.66E-03 | 5.54E-03 |
| | Dk after water absorption test | 2.05 | 2.28 | 2.89 | 2.05 | 2.31 |
| | Df after water absorption test | 4.20E-03 | 2.45E-03 | 1.98E-03 | 7.70E-03 | 8.20E-03 |
| | Df change amount before and after water absorption test | 1.14E-03 | 1.00E-05 | 7.60E-05 | 3.04E-03 | 2.66E-03 |
| Metal foil-clad laminate | Copper foil peel strength (N/mm) | 0.2 | 0.7 | 0.5 | 0.3 | 0.2 |
| | Reliability test | C | AA | B | C | C |

[Table 4]

Table 4

| | | | Example 11 | Comparative Example 6 | Example 12 | Comparative Example 7 | Example 13 | Comparative Example 8 |
|---|---|---|---|---|---|---|---|---|
| Particles | | Type | Hollow particles 1 | - | Hollow particles 1 | - | Hollow particles 1 | - |
| | | Percentage (%) of particles having one hollow portion | 100 | - | 100 | - | 100 | - |
| | | Percentage (%) of irregular-shaped particles | 2.2 | - | 2.2 | - | 22 | - |
| | | Dv ($\mu$m) | 2.6 | - | 2.6 | - | 2.6 | - |
| | | Dn ($\mu$m) | 1.9 | - | 1.9 | - | 1.9 | - |
| | | Dv/Dn | 1.37 | - | 1.37 | - | 1.37 | - |
| | | Void ratio (%) | 70 | - | 70 | - | 70 | - |
| | | Relative permittivity at 10 GHz | 1.36 | - | 1.36 | - | 1.36 | - |
| | | Dielectric dissipation factor at 10 GHz | 5.60E-04 | - | 5.60E-04 | - | 5.60E-04 | - |
| | | Unsaturated bond amount (mmol/m$^2$) | 0.161 | - | 0.161 | - | 0.161 | - |
| | | Thermal expansion coefficient (/°C) | 5.3E-05 | - | 5.3E-05 | - | 5.3E-05 | - |
| | | Electric conductivity ($\mu$S/cm) of aqueous dispersion | 8.1 | - | 8.1 | - | 8.1 | - |
| | | Residual metal amount (ppm) | 14 | - | 14 | - | 14 | - |
| Matrix resin | | Type | Modified PPE | Modified PPE | Modified PPE Allyl resin | Modified PPE Allyl resin | Maleimide resin | Maleimide resin |
| | | Functional group reactive with particles | Methacryloyl group | - | Vinyl group Allyl group | - | Maleimide group | - |

(continued)

| | | Example 11 | Comparative Example 6 | Example 12 | Comparative Example 7 | Example 13 | Comparative Example 8 |
|---|---|---|---|---|---|---|---|
| Resin film | Relative permittivity (Dk) at 10 GHz | 1.98 | 2.40 | 1.95 | 2.35 | 2.24 | 2.82 |
| | Dielectric dissipation factor (Df) at 10 GHz | 2.15E-03 | 3.02E-03 | 1.82E-03 | 2.59E-03 | 2.13E-03 | 3.10E-03 |
| | Dk after water absorption test | 1.98 | 2.41 | 1.95 | 2.35 | 2.24 | 2.82 |
| | Df after water absorption test | 2.16E-03 | 3.03E-03 | 1.83E-03 | 2.60E-03 | 2.14E-03 | 3.11E-03 |
| | Df change amount before and after water absorption test | 6.00E-06 | 9.00E-06 | 8.00E-06 | 1.00E-05 | 8.00E-06 | 1.00E-05 |
| Metal foil-clad laminate | Copper foil peel strength (N/mm) | 0.7 | 0.7 | 0.8 | 0.8 | 0.9 | 0.9 |
| | Reliability test | AA | AA | AA | AA | AA | AA |

[Consideration]

Since the hollow particles used in Comparative Example 1 had a low void ratio and a high relative permittivity, the resin film produced by use of the resin composition of Comparative Example 1 had a high relative permittivity. Also, the resin film produced by use of the resin composition of Comparative Example 1 had a large Df change amount before and after the water absorption test and had poor reliability. The metal foil-clad laminate produced by use of the resin composition of Comparative Example 1 had a low copper foil peel strength, was likely to cause an abnormality in the reliability test, and had poor reliability. It was thought that the sodium dodecylbenzene sulfonate remained in the hollow particles used in Comparative Example 1, and it was estimated that as a result, the crosslinking reaction between the matrix resin and the hollow particles did not proceed, and poor reliability was obtained, accordingly.

In Comparative Example 2, the hollow particles were not used. Accordingly, a deterioration in reliability resulting from the hollow particles did not occur in the resin film and metal foil-clad laminate produced by use of the resin composition of Comparative Example 2. However, the resin film produced by use of the resin composition of Comparative Example 2 had a high relative permittivity and a high dielectric dissipation factor.

In Comparative Example 3, commercially-available silica particles not having a hollow portion were used instead of the hollow particles. Since the silica particles had a high relative permittivity, the resin film produced by use of the resin composition of Comparative Example 3 had a high relative permittivity.

In Comparative Example 4, commercially-available hollow glass particles were used as the hollow particles. The hollow glass particles had a high relative permittivity and a high dielectric dissipation factor, and the unsaturated bond amount was small. Accordingly, the resin film produced by use of the resin composition of Comparative Example 4 had a high relative permittivity and a high dielectric dissipation factor. Also, the resin film had a large Df change amount before and after the water absorption test and had poor reliability. The metal foil-clad laminate produced by use of the resin composition of Comparative Example 4 had a low copper foil peel strength, was likely to cause an abnormality in the reliability test, and had poor reliability.

In Comparative Example 5, commercially-available hollow urethane particles were used as the hollow particles. The hollow urethane particles had a low void ratio; they had a high relative permittivity and a high dielectric dissipation factor; and the unsaturated bond amount was small. Accordingly, the resin film produced by use of the resin composition of Comparative Example 5 had a high relative permittivity and a high dielectric dissipation factor. Also, the resin film had a large Df change amount before and after the water absorption test and had poor reliability. The metal foil-clad laminate produced by use of the resin composition of Comparative Example 5 had a low copper foil peel strength, was likely to cause an abnormality in the reliability test, and had poor reliability.

The resin compositions of Examples contained the hollow particles low in relative permittivity and dielectric dissipation factor, which had a void ratio of 55% or more, a relative permittivity of 1.50 or less, a reactive unsaturated bond on the particle surface, and an unsaturated bond amount of 0.010 mmol/m$^2$ or more, and the modified polyphenylene ether resin as the matrix resin, which had the vinyl group reactive with the reactive unsaturated bond of the hollow particles. Accordingly, the resin films formed by use of the resin compositions of Examples had a low relative permittivity and a low dielectric dissipation factor; they had a small Df change amount before and after the water absorption test and had excellent dielectric property and reliability. The metal foil-clad laminates produced by use of the resin compositions of Examples had a large copper foil peel strength, were less likely to cause an abnormality in the reliability test, and had excellent reliability.

Especially, in Examples that used the hollow particles having an unsaturated bond amount of 0.070 mmol/m$^2$ or more, the resin film and the metal foil-clad laminate had excellent reliability. In Examples that used the hollow particles having an unsaturated bond amount of 0.080 mmol/m$^2$ or more, the resin film and the metal foil-clad laminate had more excellent reliability.

The resin compositions of Examples 11, 12 and 13 contained the hollow particles 1 as with Example 1, and the type of the matrix resin was different from the resin composition of Example 1. The resin compositions of Comparative Examples 6, 7 and 8 were the same as the resin compositions of Examples 11, 12 and 13, respectively, except for that they did not contain hollow particles. Due to the influence of the matrix resin, the resin films produced by use of the resin compositions of Examples 11, 12 and 13 had a high relative permittivity and a high dielectric dissipation factor compared to Example 1; however, they had a low relative permittivity and a low dielectric dissipation factor compared to the resin films of Comparative Examples 6, 7 and 8 which used the same matrix resin and which did not contain hollow particles. Accordingly, the relative permittivity and dielectric dissipation factor of the resin films of Examples 11, 12 and 13 were decreased by containing the hollow particles. Also, the resin films produced by use of the resin compositions of Examples 11, 12 and 13 had a small Df change amount before and after the water absorption test and had excellent reliability. The metal foil-clad laminates produced by use of the resin compositions of Examples 11, 12 and 13 had a large copper foil peel strength, were less likely to cause an abnormality in the reliability test, and had excellent reliability. The resin films and metal foil-clad laminates produced by use of the resin compositions of Comparative Examples 6, 7 and 8 showed no deterioration in reliability resulting from the hollow particles.

Reference Signs List

1. Aqueous medium
2. Low polarity material
3. Monomer composition droplet
4a. Hydrophobic solvent
4b. Material not containing hydrophobic solvent
5. Precursor particle
6. Shell
7. Hollow portion
10A. Hollow particles after solvent removal step
10B. Hollow particles after washing step
11. Stirring tank
12. Supply tank
13a, 13b, 13c. Gas inlet
14. Outlet
15. Spray mechanism
16. Supply line to stirring tank
17a, 17b. Circulation line
20. Precursor composition
21. Vapor phase

**Claims**

1. A resin composition comprising hollow particles and a matrix resin,

   wherein the hollow particles comprises a shell containing a resin and a hollow portion surrounded by the shell; the hollow particles have a void ratio of 55% or more; the hollow particles have a relative permittivity of 1.50 or less at a frequency of 10 GHz; the hollow particles have a reactive unsaturated bond on a surface of the particles; the hollow particles have an unsaturated bond amount per unit area of 0.010 mmol/m$^2$ or more, which is obtained from an iodine value and specific surface area of the hollow particles by the following formula (A):

   Unsaturated bond amount (mmol/m$^2$) = Iodine value (mmol/g) / Specific surface area (m$^2$/g)     Formula (A),

   and
   wherein the matrix resin comprises a matrix resin containing a functional group which is reactive with the reactive unsaturated bond of the hollow particles.

2. The resin composition according to Claim 1, wherein the functional group of the matrix resin is at least one selected from the group consisting of a (meth)acryloyl group, a vinyl group, an allyl group, a thiol group and a maleimide group.

3. The resin composition according to Claim 1 or 2, wherein a total content of a surfactant and water-soluble polymer stabilizer present on a surface of the hollow particles is 500 ppm or less.

4. The resin composition according to Claim 1 or 2, wherein the shell of the hollow particles contains, as the resin, a polymer containing 50% by mass or more of a crosslinkable monomer unit.

5. The resin composition according to Claim 4, wherein the polymer contains 70% by mass or more of a hydrocarbon monomer unit.

6. The resin composition according to Claim 1 or 2, wherein the hollow particles have a dielectric dissipation factor of 1.0 × 10$^{-3}$ or less at a frequency of 10 GHz.

7. The resin composition according to Claim 1 or 2, wherein the hollow particles have a thermal expansion coefficient of 1.0 × 10$^{-4}$/°C or less at 23°C to 100°C.

8. The resin composition according to Claim 1 or 2, wherein the hollow particles have a volume average particle diameter of from 0.1 μm to 10.0 μm.

9. The resin composition according to Claim 1 or 2, wherein the matrix resin comprises at least one selected from the group consisting of a bis-maleimide resin, a hydrocarbon resin, an unsaturated polyester resin, a modified polyphenylene ether resin, an allyl resin, a thiol resin and raw material compounds of these resins.

10. A prepreg obtained by impregnating a substrate with the resin composition defined in any one of Claims 1 to 9 and heat-drying the substrate, wherein the prepreg contains a semi-cured product of the resin composition, and wherein at least some of the hollow particles in the semi-cured product are cross-linked to the matrix resin.

11. A metal foil-clad laminate obtained by hot-pressing a prepreg laminate which is a laminate of the prepregs defined in Claim 10 and a metal foil which is in contact with the prepreg laminate, wherein the metal foil-clad laminate comprises a cured product of the prepreg laminate, and wherein at least some of the hollow particles in the cured product are cross-linked to the matrix resin.

12. The metal foil-clad laminate according to Claim 11, wherein a peel strength between the cured product of the prepreg laminate and the metal foil is 0.5 N/mm or more.

13. A metal foil-clad laminate comprising an insulation layer comprising a cured product of the resin composition defined by any one of Claims 1 to 9 and a substrate, and a metal foil in contact with the insulation layer, wherein at least some of the hollow particles in the cured product of the resin composition are cross-linked to the matrix resin.

14. The metal foil-clad laminate according to Claim 13, wherein a peel strength between the insulation layer and the metal foil is 0.5 N/mm or more.

**15.** A printed circuit board comprising the metal foil-clad laminate defined in Claim 11.

**16.** A printed circuit board comprising the metal foil-clad laminate defined in Claim 13.

[FIG. 1]

[FIG. 2]

## INTERNATIONAL SEARCH REPORT

| International application No. |
| --- |
| **PCT/JP2023/042733** |

**A. CLASSIFICATION OF SUBJECT MATTER**

*C08L 101/00*(2006.01)i; *B32B 15/08*(2006.01)i; *C08F 299/02*(2006.01)i; *C08K 7/22*(2006.01)i; *H05K 1/03*(2006.01)i
FI:  C08L101/00; C08K7/22; C08F299/02; B32B15/08 105Z; B32B15/08 J; H05K1/03 610H

According to International Patent Classification (IPC) or to both national classification and IPC

**B. FIELDS SEARCHED**

Minimum documentation searched (classification system followed by classification symbols)

C08L101/00; B32B15/08; C08F299/02; C08K7/22; H05K1/03

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
| --- | --- | --- |
| P, X | WO 2023/106307 A1 (NIPPON ZEON CO.) 15 June 2023 (2023-06-15)<br>claims, paragraphs [0073], [0090], examples | 1-9 |
| A | JP 2022-96299 A (SEKISUI PLASTICS CO., LTD.) 29 June 2022 (2022-06-29) | 1-16 |
| A | WO 2022/202046 A1 (KANEKA CORP.) 29 September 2022 (2022-09-29) | 1-16 |
| A | JP 2022-96300 A (SEKISUI PLASTICS CO., LTD.) 29 June 2022 (2022-06-29) | 1-16 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **31 January 2024** | **13 February 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2023/042733**

| Patent document cited in search report | | | Publication date (day/month/year) | Patent family member(s) | | | Publication date (day/month/year) |
|---|---|---|---|---|---|---|---|
| WO | 2023/106307 | A1 | 15 June 2023 | (Family: none) | | | |
| JP | 2022-96299 | A | 29 June 2022 | TW | 202235152 | A | |
| | | | | CN | 116615470 | A | |
| | | | | KR | 10-2023-0096102 | A | |
| WO | 2022/202046 | A1 | 29 September 2022 | (Family: none) | | | |
| JP | 2022-96300 | A | 29 June 2022 | WO | 2022/131022 | A1 | |
| | | | | TW | 202235154 | A | |
| | | | | CN | 116615471 | A | |
| | | | | KR | 10-2023-0096103 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2022202046 A

- JP 2008031409 A

**Non-patent literature cited in the description**

- Chemical Society of Japan. Maruzen Publishing Co., Ltd., 30 September 1993, 498-503